# EUROPEAN PATENT APPLICATION

(11) **EP 4 529 394 A1**
(43) Date of publication of application: **26.03.2025**
(21) Application number: 23807756.4
(22) Date of filing: 09.03.2023
(51) Int. Cl.: H10K 50/842, H10K 71/50, H10K 59/131, H10K 59/126, H10K 59/124, H10K 59/123, H10K 50/81, H10K 50/82, H10K 59/122, H10K 59/38

(54) **DISPLAY DEVICE AND MANUFACTURING METHOD THEREFOR**

(30) Priority: 20.05.2022 KR 20220062191
(71) Applicant: Samsung Display Co., Ltd., Yongin-si, Gyeonggi-do 17113 (KR)
(72) Inventor: KIM, Hyung Jun, Yongin-si Gyeonggi-do 17113 (KR); KIM, Eok Su, Yongin-si Gyeonggi-do 17113 (KR); KIM, Hyoung Do, Yongin-si Gyeonggi-do 17113 (KR); NAM, Yun Yong, Yongin-si Gyeonggi-do 17113 (KR); PARK, Joon Seok, Yongin-si Gyeonggi-do 17113 (KR); LIM, Jun Hyung, Yongin-si Gyeonggi-do 17113 (KR)
(74) Representative: Marks & Clerk LLP
(86) International application number: PCT/KR2023/003233
(87) International publication number: WO 2023/224232

(57) **Abstract**

This display device comprises: a first substrate in which a display region and a non-display region located around the display region are defined; a second substrate arranged on the first substrate; and a sealing member which is arranged in a sealing region of the non-display region and couples the first substrate to the second substrate. The first substrate comprises: a first conductive layer comprising a first base portion, a first signal wiring on the first base portion, and a lower light-blocking layer; a buffer layer on the first conductive layer; a semiconductor layer on the buffer layer, the semiconductor layer overlapping the lower light-blocking layer; a gate insulating layer on the semiconductor layer; and a second conductive layer on the gate insulating layer, the second conductive layer comprising a second signal wiring and a third signal wiring, which are electrically connected to the first signal wiring, and a gate electrode overlapping the semiconductor layer.

## Description

### [Technical Field]

The present disclosure relates to a display device and a method of manufacturing the same.

### [Background Art]

The importance of display devices has steadily increased with the development of multimedia technology. Accordingly, various types of display devices such as a liquid crystal display (LCD) device, an organic light emitting diode (OLED) display device and the like have been developed.

Among the display devices, a self-light emitting display device includes a self-light emitting element such as an organic light emitting element. The self-light emitting element may include two opposite electrodes and a light emitting layer interposed therebetween. In the case of using the organic light emitting element as the self-light emitting element, the electrons and holes from the two electrodes are recombined in the light emitting layer to produce excitons, which transition from the excited state to the ground state, emitting light.

The self-light emitting display device is attracting attention as a next-generation display device because of being able to meet the high display quality requirements such as wide viewing angle, high brightness and contrast, and quick response speed as well as being able to be made having a low power consumption, lightweight, and thin due to no necessity of a power source such as a backlight unit.

### [Disclosure]

### [Technical Problem]

Aspects of the present disclosure provide a display device having improved moisture permeability through a sealing area from the outside.

Aspects of the present disclosure also provide a method of manufacturing a display device having improved moisture permeability through a sealing area from the outside.

However, aspects of the present disclosure are not restricted to those set forth herein. The above and other aspects of the present disclosure will become more apparent to one of ordinary skill in the art to which the present disclosure pertains by referencing the detailed description of the present disclosure given below.

### [Technical Solution]

According to an aspect of the present disclosure, there is provided a display device including a first substrate in which a display area and a non-display area positioned around the display area are defined, a second substrate disposed on the first substrate, and a sealing member disposed in a sealing area of the non-display area to bond the first substrate to the second substrate. The first substrate comprises a first base portion, a first conductive layer comprising a first signal line and a lower light blocking layer, on the first base portion, a buffer layer on the first conductive layer, a semiconductor layer overlapping the lower light blocking layer, on the buffer layer, a gate insulating layer on the semiconductor layer, and a second conductive layer comprising a second signal line and a third signal line electrically connected to the first signal line, and a gate electrode overlapping the semiconductor layer, on the gate insulating layer. In plan view, the first signal line is disposed between the second signal line and the third signal line, and the first signal line is disposed to overlap the sealing member.

According to an aspect of the present disclosure, there is provided a method of manufacturing a display device including the steps of, forming a first substrate in which a display area and a non-display area positioned around the display area are defined, and bonding a second substrate to the first substrate through a sealing member disposed in a sealing area of the non-display area. The forming of the first substrate comprises, forming a first conductive layer comprising a first signal line and a lower light blocking layer, on the first base portion, forming a buffer layer on the first conductive layer, forming a semiconductor layer overlapping the lower light blocking layer, on the buffer layer, forming a gate insulating layer on the semiconductor layer, forming, on the gate insulating layer, a second conductive layer comprising a second signal line and a third signal line electrically connected to the first signal line, a first pad connected to an outer end of the second signal line, and a gate electrode overlapping the semiconductor layer, forming a passivation layer on the second conductive layer, and forming a via layer on the passivation layer. In plan view, the first signal line is disposed between the second signal line and the third signal line, the first signal line is disposed to overlap the sealing member, and in the forming of the via layer, a thickness of the via layer in the sealing area is smaller than a thickness of the via layer in an area excluding the sealing area.

Specific details of other embodiments are included in the detailed description and drawings.

### [Advantageous Effects]

According to embodiments of the present disclosure, moisture permeation through the sealing area from the outside may be improved.

However, the effects of the present disclosure are not limited to the aforementioned effects, and various other effects are included in the present disclosure.

### [Description of Drawings]

FIG. 1 is a cross-sectional view illustrating a schematic stacked structure of a display device according to one embodiment;
FIG. 2 is a plan view of a display device according to one embodiment;
FIG. 3 is a pixel circuit diagram of a display device according to one embodiment;
FIG. 4 is an enlarged plan view of portion Q1 of FIG. 2, and more specifically, is a schematic plan view of a display substrate included in the display device of FIG. 2;
FIG. 5 is an enlarged plan view of portion Q1 of FIG. 2, and more specifically, is a schematic plan view of a color conversion substrate included in the display device of FIG. 2;
FIG. 6 is a plan view illustrating a modified example of FIG. 4;
FIG. 7 is a plan view illustrating a modified example of FIG. 5;
FIG. 8 is an enlarged plan view of portion Q3 of FIG. 2;
FIG. 9 is a cross-sectional view of a display device according to one embodiment taken along line X1-X1' of FIG. 5;
FIG. 10 is an enlarged cross-sectional view of portion Q4 of FIG. 9;
FIG. 11 is a cross-sectional view illustrating a modified example of the structure shown in FIG. 10;
FIG. 12 is a cross-sectional view of a display device according to one embodiment taken along line X3-X3' of FIG. 8;
FIG. 13 is a plan view illustrating a schematic arrangement of a third color filter in a color conversion substrate of a display device according to one embodiment;
FIG. 14 is a plan view illustrating a schematic arrangement of a first color filter in a color conversion substrate of a display device according to one embodiment;
FIG. 15 is a plan view illustrating a schematic arrangement of a second color filter in a color conversion substrate of a display device according to one embodiment;
FIGS. 16 to 23 are cross-sectional views illustrating process steps of a manufacturing method of a display device according to one embodiment;
FIG. 24 is a cross-sectional view of a display device according to another embodiment;
FIG. 25 is a plan view illustrating a non-display area and a display area of a display device according to still another embodiment;
FIG. 26 is a cross-sectional view of a display device according to one embodiment taken along line X3-X3' of FIG. 25;
FIG. 27 is a plan view illustrating a non-display area and a display area of a display device according to still another embodiment;
FIG. 28 is a cross-sectional view of a display device according to one embodiment taken along line X3-X3' of FIG. 27;
FIG. 29 is a cross-sectional view of a display device according to still another embodiment;
FIG. 30 is a cross-sectional view of a display device according to still another embodiment;
FIG. 31 is a cross-sectional view of a display device according to still another embodiment;
FIG. 32 is a cross-sectional view of a display device according to still another embodiment; and
FIG. 33 is a cross-sectional view of a display device according to still another embodiment.

### [Mode for Invention]

The advantages and features of the present invention, and the methods for achieving them, will become clearer with reference to the embodiments described below in detail with the accompanying drawings. However, the present invention is not limited to the embodiments disclosed below, but may be implemented in various different forms, and the embodiments are provided only to make the disclosure of the present invention complete and to fully inform those skilled in the art of the scope of the invention, and the present invention is defined only by the scope of the claims.

When elements or layers are referred to as being 'on' another element or layer, it includes all cases where the other layer or other elements are directly on the other element or intervening. On the other hand, when an element is referred to as being 'directly on', it indicates that there are no intervening elements or layers. Like reference numerals refer to like elements throughout the specification.

The spatially relative terms 'below', 'beneath', 'lower', 'above', 'upper', etc. can be used to easily describe the relationship between one element or component and other elements or components as depicted in the drawings. The spatially relative terms should be understood as terms that include different directions of elements when used in addition to the directions depicted in the drawings. For example, if an element depicted in the drawings is flipped, an element described as 'below' or 'beneath' another element may be located 'above' the other element. Thus, the exemplary term 'below' can include both directions.

Although first, second, third, fourth, etc. are used to describe various elements, these elements are not limited by these terms. These terms are used only to distinguish one element from another. Therefore, it goes without saying that the first component mentioned below may be any one of the second component, the third component, and the fourth component within the technical idea of the present invention.

The embodiments described in this specification will be described with reference to the plan view and the cross-sectional view, which are ideal schematic diagrams of the present invention. Therefore, the shape of the example drawing may be modified due to manufacturing technology and/or tolerance, etc. Accordingly, the embodiments of the present invention are not limited to the specific shape illustrated, but also include changes in the shape generated according to the manufacturing process. Accordingly, the regions illustrated in the drawings have schematic properties, and the shapes of the regions illustrated in the drawings are intended to illustrate specific shapes of the regions of the elements, and are not intended to limit the scope of the invention.

Hereinafter, embodiments of the present invention will be described with reference to the attached drawings.

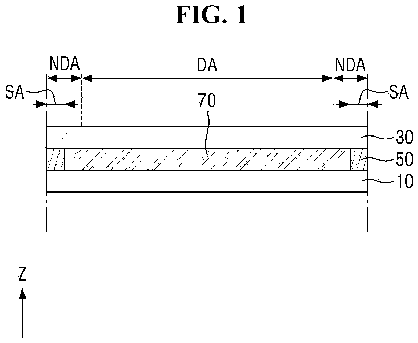

FIG. 1 is a cross-sectional view illustrating a schematic stacked structure of a display device according to one embodiment.

Referring to FIG. 1, a display device 1 may be applied to a variety of electronic apparatuses, i.e., small and medium electronic devices such as a tablet PC, a smartphone, a car navigation unit, a camera, a center information display (CID) provided in a vehicle, a wristwatch-type electronic device, a personal digital assistant (PDA), a portable multimedia player (PMP) and a game console, and medium and large electronic devices such as a television, an external billboard, a monitor, a personal computer and a laptop computer. These are merely suggested as examples, but the display device 1 may also be applied to other electronic devices without departing from the present inventive concept.

The display device 1 may include a display area DA displaying an image and a non-display area NDA not displaying an image. In some embodiments, the non-display area NDA may be located around the display area DA and may surround the display area DA. An image displayed in the display area DA may be visually recognized by a user in a third direction Z to which an arrow of the drawing is directed.

When describing the schematic stacked structure of the display device 1, in some embodiments, as shown in FIG. 1, the display device 1 includes a display substrate 10 and a color conversion substrate 30 facing the display substrate 10, and may further include a sealing member 50 that bonds the display substrate 10 to the color conversion substrate 30, and a filler 70 that is filled between the display substrate 10 and the color conversion substrate 30.

The display substrate 10 may include elements and circuits for displaying an image, for example, a pixel circuit such as a switching element, a pixel defining layer and a self-light emitting element that define an emission area and a non-emission area, which will be described later, in the display area DA. In an embodiment, the self-light emitting element may include at least one of an organic light emitting element (organic light emitting diode), a quantum dot light emitting element (quantum dot light emitting diode), an inorganic material-based micro light emitting diode (e.g., micro LED), and an inorganic material-based light emitting diode (e.g., nano LED) having a nano size. Hereinafter, for simplicity of description, a case in which the self-light emitting element is an organic light emitting element will be described as an example.

The color conversion substrate 30 may be located above the display substrate 10 to face the display substrate 10. In some embodiments, the color conversion substrate 30 may include a color conversion pattern for converting a color of incident light. In some embodiments, the color conversion substrate 30 may include at least one of a color filter and a wavelength conversion pattern, as the color conversion pattern. In some embodiments, the color conversion substrate 30 may include both the color filter and the wavelength conversion pattern.

The sealing member 50 may be positioned between the display substrate 10 and the color conversion substrate 30 in the non-display area NDA. The sealing member 50 may be disposed along the edges of the display substrate 10 and the color conversion substrate 30 in the non-display area NDA to surround the display area DA in plan view. The display substrate 10 and the color conversion substrate 30 may be bonded to each other through the sealing member 50.

In some embodiments, the sealing member 50 may be made of an organic material. For example, the sealing member 50 may be made of an epoxy-based resin, but is not limited thereto. In some other embodiments, the sealing member 50 may be applied in the form of a frit including glass or the like.

The filler 70 may be positioned in a space between the display substrate 10 and the color conversion substrate 30 surrounded by the sealing member 50. The filler 70 may fill a space between the display substrate 10 and the color conversion substrate 30.

In some embodiments, the filler 70 may be made of a material that can transmit light. In some embodiments, the filler 70 may be made of an organic material. For example, the filler 70 may be made of a silicone-based organic material, an epoxy-based organic material, a mixture of a silicone-based organic material and an epoxy-based organic material, or the like.

In some embodiments, the filler 70 may be made of a material having an extinction coefficient of substantially zero. There is a correlation between a refractive index and an extinction coefficient, and as the refractive index decreases, the extinction coefficient also decreases. In addition, when the refractive index is 1.7 or less, the extinction coefficient may substantially converge to zero. In some embodiments, the filler 70 may be made of a material having a refractive index of 1.7 or less, and thus may prevent or minimize light provided from the self-light emitting element from being absorbed while passing through the filler 70. In some embodiments, the filler 70 may be made of an organic material having a refractive index of 1.4 to 1.6.

Although the display device 1 is illustrated as including the display substrate 10, the color conversion substrate 30, the sealing member 50, and the filler 70 in FIG. 1, in some embodiments, the sealing member 50 and the filler 70 may be omitted in the display device 1, and the components of the color conversion substrate 30 excluding a second base portion 310 may be disposed on the display substrate 10.

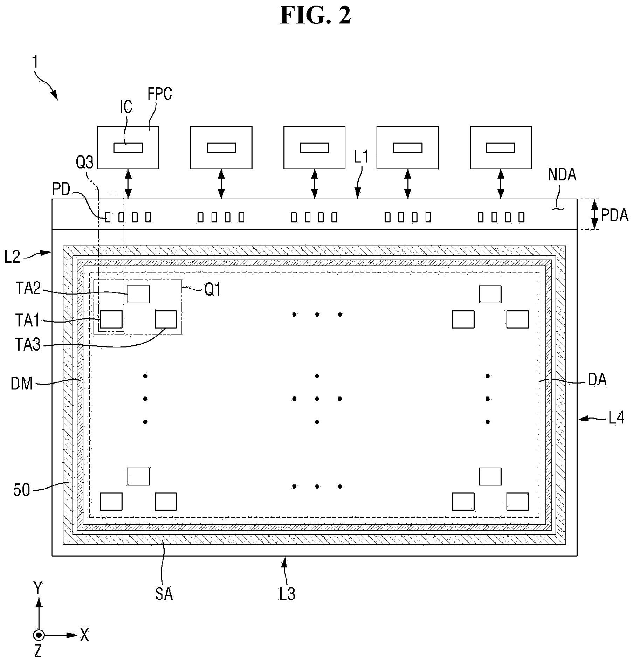

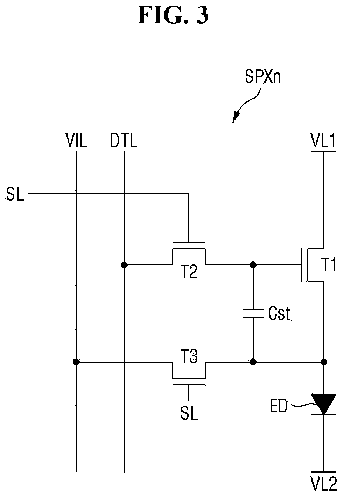

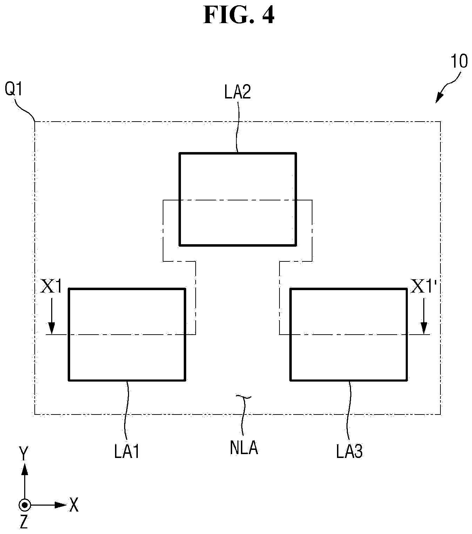

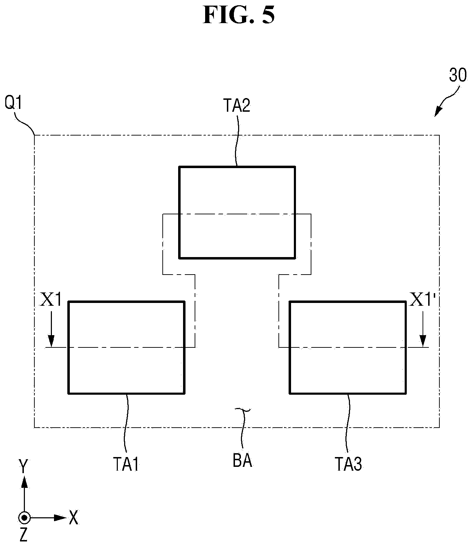

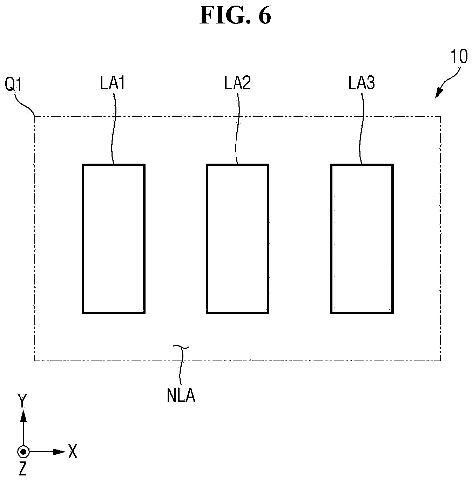

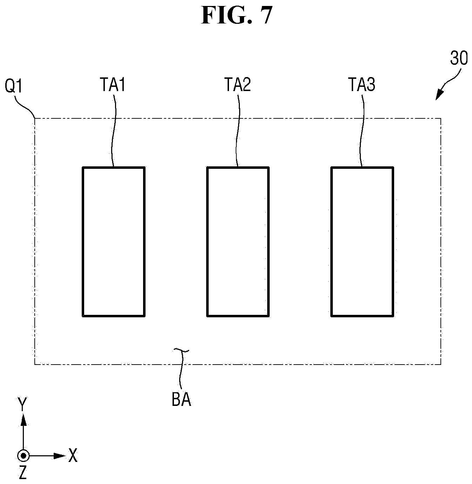

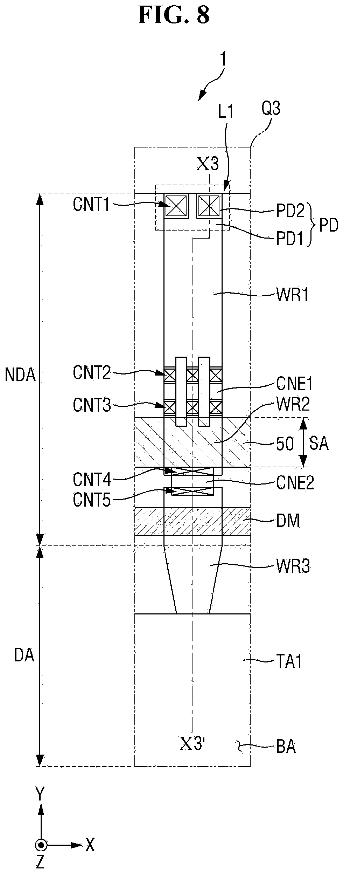

FIG. 2 is a plan view of a display device according to one embodiment. FIG. 3 is a pixel circuit diagram of a display device according to one embodiment. FIG. 4 is an enlarged plan view of portion Q1 of FIG. 2, and more specifically, is a schematic plan view of a display substrate included in the display device of FIG. 2. FIG. 5 is an enlarged plan view of portion Q1 of FIG. 2, and more specifically, is a schematic plan view of a color conversion substrate included in the display device of FIG. 2. FIG. 6 is a plan view illustrating a modified example of FIG. 4. FIG. 7 is a plan view illustrating a modified example of FIG. 5. FIG. 8 is an enlarged plan view of portion Q3 of FIG. 2.

Referring further to FIGS. 2 to 8 in addition to FIG. 1, in some embodiments, as shown in FIG. 2, the display device 1 may have a rectangular shape in plan view. The display device 1 may include two sides, i.e., a first side L1 and a third side L3, extending in a first direction X and two sides, i.e., a second side L2 and a fourth side L4, extending in a second direction Y intersecting the first direction X. A corner where the sides of the display device 1 meet may be right-angled, but is not limited thereto. In some embodiments, the length of the first side L1 and the third side L3 and the length of the second side L2 and the fourth side L4 may be different from each other. For example, the first side L1 and the third side L3 may be relatively longer than the second side L2 and the fourth side L4. The planar shape of the display device 1 is not limited to the exemplified one, but may have a circular shape or other shapes.

In some embodiments, the display device 1 may further include a flexible circuit board FPC and a driving chip IC.

The display area DA may include a plurality of pixels. The pixel may include a plurality of sub-pixels SPXn (see FIG. 3). The plurality of sub-pixels SPXn may include a first sub-pixel, a second sub-pixel, and a third sub-pixel, and the sub-pixels SPXn may be formed to correspond to a plurality of emission areas LA1, LA2, and LA3 of the display substrate 10 to be described later.

As shown in FIG. 4, the plurality of emission areas LA1, LA2, and LA3 and a non-emission area NLA may be defined on the display substrate 10 in the display area DA.

In some embodiments, a first emission area LA1, a second emission area LA2, and a third emission area LA3 may be defined in the display area DA of the display substrate 10. In the first emission area LA1, the second emission area LA2, and the third emission area LA3, light generated from the light emitting element of the display substrate 10 may be emitted to the outside of the display substrate 10, and in the non-emission area NLA, light may not be emitted to the outside of the display substrate 10. In some embodiments, the non-emission area NLA may surround each of the first emission area LA1, the second emission area LA2, and the third emission area LA3 in the display area DA.

In some embodiments, light emitted to the outside from the first emission area LA1, the second emission area LA2, and the third emission area LA3 may be light of a third color. In some embodiments, the light of the third color may be blue light, and may have a peak wavelength ranging from about 440 nm to about 480 nm. Here, the peak wavelength means a wavelength at which the intensity of light is maximum.

In some embodiments, the first emission area LA1, the second emission area LA2, and the third emission area LA3 may form one group, and a plurality of groups may be defined in the display area DA.

As shown in FIG. 4, the first emission area LA1 and the third emission area LA3 may be adjacent to each other in the first direction X, and the second emission area LA2 may be positioned to one side of the first emission area LA1 and the third emission area LA3 in the second direction Y. However, the present disclosure is not limited thereto, and the arrangement of the first emission area LA1, the second emission area LA2, and the third emission area LA3 may be variously changed. For example, as shown in FIG. 6, the first emission area LA1, the second emission area LA2, and the third emission area LA3 may be sequentially positioned along the first direction X. In some embodiments, in the display area DA, the first emission area LA1, the second emission area LA2, and the third emission area LA3 may form one group to be repeatedly arranged along the first direction X and the second direction Y.

Hereinafter, a case in which the first emission area LA1, the second emission area LA2, and the third emission area LA3 are disposed as shown in FIG. 4 will be described as an example.

As shown in FIG. 5, a plurality of light transmitting areas TA1, TA2, and TA3 and a light blocking area BA may be defined on the color conversion substrate 30 in the display area DA. The light transmitting areas TA1, TA2, and TA3 may be regions where light emitted from the display substrate 10 passes through the color conversion substrate 30 and is provided to the outside of the display device 1. The light blocking area BA may be a region where light emitted from the display substrate 10 does not transmit.

In some embodiments, a first light transmitting area TA1, a second light transmitting area TA2, and a third light transmitting area TA3 may be defined on the color conversion substrate 30.

The first light transmitting area TA1 may correspond to or overlap the first emission area LA1. Similarly, the second light transmitting area TA2 may correspond to or overlap the second emission area LA2, and the third light transmitting area TA3 may correspond to or overlap the third emission area LA3.

As shown in FIG. 4, when the first emission area LA1 and the third emission area LA3 are adjacent to each other in the first direction X, and the second emission area LA2 is positioned to one side of the first emission area LA1 and the third emission area LA3 in the second direction Y, as shown in FIG. 5, the first light transmitting area TA1 and the third light transmitting area TA3 may be adjacent to each other in the first direction X, and the second light transmitting area TA2 may be positioned to one side of the first light transmitting area TA1 and the third light transmitting area TA3 in the second direction Y.

In some embodiments, as shown in FIG. 6, when the first emission area LA1, the second emission area LA2, and the third emission area LA3 are sequentially positioned along the first direction X, as shown in FIG. 7, the first light transmitting area TA1, the second light transmitting area TA2, and the third light transmitting area TA3 may also be sequentially positioned along the first direction X.

In some embodiments, a shape of each of the first light transmitting area TA1, the second light transmitting area TA2, and the third light transmitting area TA3 may be a quadrangle in plan view. For example, the quadrangle may be a rectangle or a square. However, the present disclosure is not limited thereto, and the first light transmitting area TA1, the second light transmitting area TA2, and the third light transmitting area TA3 may each have a circular shape, an elliptical shape, or another polygonal shape in plan view.

In some embodiments, the light of the third color provided from the display substrate 10 may pass through the first light transmitting area TA1, the second light transmitting area TA2, and the third light transmitting area TA3 and be emitted to the outside. When the light emitted from the first light transmitting area TA1 to the outside of the display device 1 is referred to as first emission light, the light emitted from the second light transmitting area TA2 to the outside of the display device 1 is referred to as second emission light and the light emitted from the third light transmitting area TA3 to the outside of the display device 1 is referred to as third emission light, the first emission light may be light of a first color, the second emission light may be light of a second color different from the first color, and the third emission light may be light of a third color. In some embodiments, the light of the third color may be blue light having a wavelength range of 380 nm to 500 nm and a peak wavelength ranging from 440 nm to 480 nm, and the light of the first color may be red light having a wavelength range of 600 nm to 780 nm and a peak wavelength ranging from 610 nm to 650 nm. In addition, the light of the second color may be green light having a wavelength range of 500 nm to 600 nm and a peak wavelength ranging from 510 nm to 550 nm.

The light blocking area BA may be positioned around the first light transmitting area TA1, the second light transmitting area TA2, and the third light transmitting area TA3 of the color conversion substrate 30 in the display area DA. In some embodiments, the light blocking area BA may surround the first light transmitting area TA1, the second light transmitting area TA2, and the third light transmitting area TA3. In addition, the light blocking area BA may also be positioned in the non-display area NDA of the display device 1.

Meanwhile, as shown in FIG. 5, the plurality of light transmitting areas TA1, TA2, and TA3 and the light blocking area BA may be defined on the color conversion substrate 30 in the display area DA. The light transmitting areas TA1, TA2, and TA3 may be regions where light emitted from the display substrate 10 passes through the color conversion substrate 30 and is provided to the outside of the display device 1. The light blocking area BA may be a region where light emitted from the display substrate 10 does not transmit.

Referring back to FIG. 2, the non-display area NDA of the display device 1 may include a sealing area SA. The sealing member 50 may be disposed in the sealing area SA, and a dam member DM may be disposed in the non-display area NDA.

The dam member DM may block an overflow of an organic material (or a monomer) in a process of forming an encapsulation layer disposed in the display area DA, thereby preventing the organic material of the encapsulation layer from extending toward the edge of the display device 1.

In some embodiments, the dam member DM may be disposed to completely surround the display area DA in plan view.

The sealing member 50 may bond the display substrate 10 and the color conversion substrate 30 to each other as described above.

The sealing member 50 may be positioned outside the dam member DM in the non-display area NDA, and may be disposed to completely surround the dam member DM and the display area DA in plan view.

The non-display area NDA of the display device 1 may include a pad area PDA, and a plurality of pad electrodes PD may be positioned in the pad area PDA.

In some embodiments, the pad electrode PD may be positioned in a portion of the non-display area NDA adjacent to the long side, for example, in a region of the non-display area NDA adjacent to the first side L1. The pad electrode PD may be electrically connected to a pixel circuit and the like located in the display area DA through a connection line or the like.

The display substrate 10 (see FIG. 1) of the display device 1 may include the dam member DM and the pad electrode PD described above.

The flexible circuit board FPC may be connected to the pad electrode PD. The flexible circuit board FPC may electrically connect the display substrate 10 (see FIG. 1) to a circuit board and the like that provides a signal, power, and the like for driving the display device 1.

The driving chip IC may be electrically connected to the circuit board and the like to receive data, a signal, and the like. In some embodiments, the driving chip IC may be a data driving chip, may receive a data control signal, image data, and the like from the circuit board and the like, and may generate and output a data voltage and the like corresponding to the image data.

In some embodiments, the driving chip IC may be mounted on the flexible circuit board FPC. For example, the driving chip IC may be mounted on the flexible circuit board FPC in the form of a chip on film (COF).

The data voltage provided from the driving chip IC, the power provided from the circuit board, and the like may be transmitted to the pixel circuit and the like of the display substrate 10 (see FIG. 1) via the flexible circuit board FPC and the pad electrode PD.

As described above, the sub-pixels SPXn may be formed to correspond to the plurality of emission areas LA1, LA2, and LA3 of the display substrate 10 to be described later. Each sub-pixel SPXn includes three transistors T1, T2, and T3, and one storage capacitor Cst in addition to a light emitting element ED.

The light emitting element ED emits light according to a current supplied through the first transistor T1. The light emitting element ED includes a first electrode, a second electrode, and at least one organic layer disposed therebetween. The light emitting element ED may emit light in a specific wavelength band by an electrical signal transmitted from the first electrode and the second electrode.

One end of the light emitting element ED may be connected to the source electrode of the first transistor T1, and the other end thereof may be connected to the second voltage line VL2 to which a low potential voltage (hereinafter, a second power voltage) lower than a high potential voltage (hereinafter, a first power voltage) of the first voltage line VL1 is supplied.

The first transistor T1 adjusts a current flowing from the first voltage line VL1, to which the first power voltage is supplied, to the light emitting element ED according to the voltage difference between the gate electrode and the source electrode. For example, the first transistor T1 may be a driving transistor for driving the light emitting element ED. The gate electrode of the first transistor T1 may be connected to the source electrode of the second transistor T2, the source electrode of the first transistor T1 may be connected to the first electrode of the light emitting element ED, and the drain electrode of the first transistor T1 may be connected to the first voltage line VL1 to which the first power voltage is applied.

The second transistor T2 is turned on by a scan signal of the scan line SL to connect the data line DTL to the gate electrode of the first transistor T1. The gate electrode of the second transistor T2 may be connected to the scan line SL, the source electrode thereof may be connected to the gate electrode of the first transistor T1, and the drain electrode thereof may be connected to the data line DTL.

The third transistor T3 is turned on by a scan signal of the scan line SL to connect the initialization voltage line VIL to one end of the light emitting element ED. The gate electrode of the third transistor T3 may be connected to the scan line SL, the drain electrode thereof may be connected to the initialization voltage line VIL, and the source electrode thereof may be connected to one end of the light emitting element ED or to the source electrode of the first transistor T1.

In one embodiment, the source electrode and the drain electrode of each of the transistors T1, T2, and T3 are not limited to those described above, and vice versa. Each of the transistors T1, T2, and T3 may be formed of a thin film transistor. In FIG. 3, each of the transistors T1, T2, and T3 has been described as being formed of an N-type metal oxide semiconductor field effect transistor (MOSFET), but is not limited thereto. For example, each of the transistors T1, T2, and T3 may be formed of a P-type MOSFET. Alternatively, some of the transistors T1, T2, and T3 may be formed of an N-type MOSFET and the others may be formed of a P-type MOSFET.

The storage capacitor Cst is formed between the gate electrode and the source electrode of the first transistor T1. The storage capacitor Cst stores a difference voltage between a gate voltage and a source voltage of the first transistor T1.

In the embodiment of FIG. 3, the gate electrodes of the second transistor T2 and the third transistor T3 may be connected to the same scan line SL. It is illustrated that the second transistor T2 and the third transistor T3 are simultaneously turned on by a scan signal applied from the same scan line, but the gate electrode of the second transistor T2 may be connected to a first scan line, and the gate electrode of the third transistor T3 may be connected to a second scan line. Here, the first scan line and the second scan line may be different scan lines, and the second transistor T2 and the third transistor T3 may be turned on in response to scan signals applied from the different scan lines. However, the present disclosure is not limited thereto.

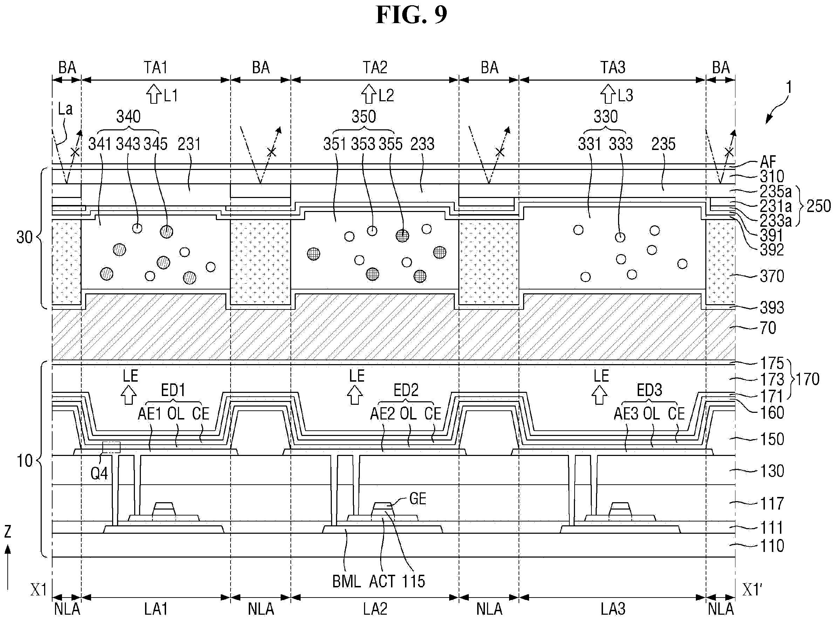

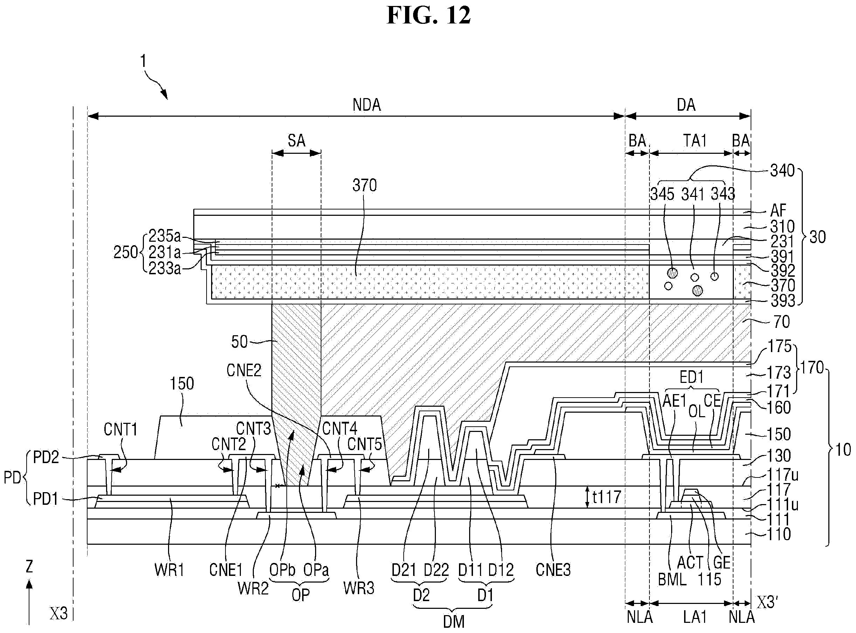

As described above, the pad electrodes PD serve to receive a driving signal, power, or the like through the flexible circuit board FPC and transmit it to the light emitting element ED of the display area DA. For example, when the pad electrode PD receives a driving signal, the corresponding pad electrode PD may be a driving pad electrode, and when the pad electrode PD receives power, the corresponding pad electrode PD may be a power pad electrode. As described above with reference to FIG. 3, two voltage lines VL1 and VL2 (or power lines) may be connected to the light emitting element ED, and each of the voltage lines VL1 and VL2 may receive the first power voltage or the second power voltage through the power pad electrodes and transmit it to the light emitting element ED. Accordingly, the power pad electrodes may include a first power pad electrode connected to the first voltage line VL1 and a second power pad electrode connected to the second voltage line VL2. The pad electrode PD in FIG. 8 is illustrated as the second power pad electrode, but is not limited thereto. Further, as shown in FIG. 8, the pad electrode PD may be connected to a light emitting element ED1, ED2, ED3 (see FIG. 9) of the display area DA through signal lines WR1, WR2, and WR3. A description of FIG. 8 will be given later in detail together with FIG. 12 to be described later.

Hereinafter, the structure of the display device 1 will be described in more detail.

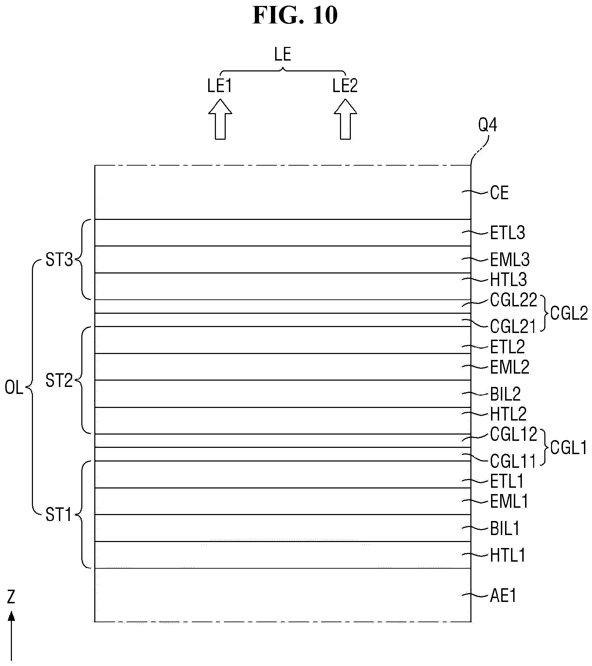

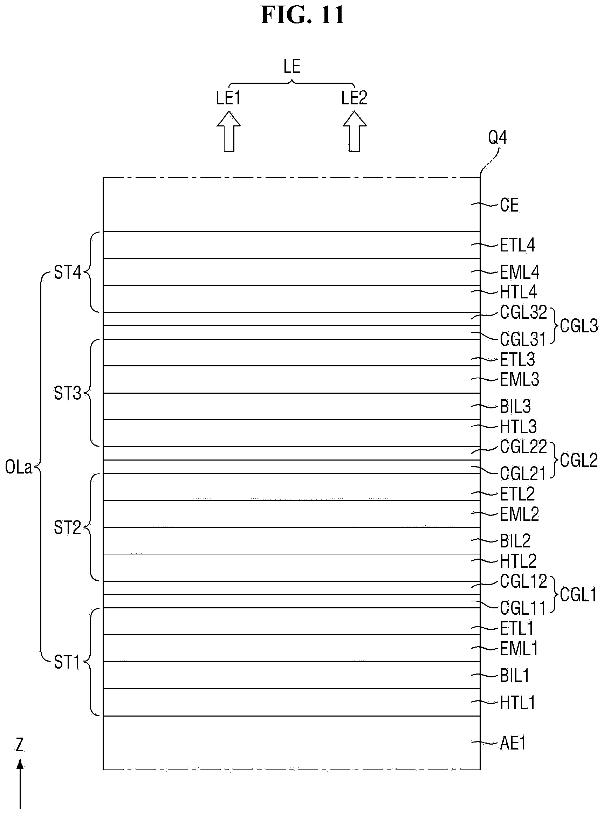

FIG. 9 is a cross-sectional view of a display device according to one embodiment taken along line X1-X1' of FIG. 5. FIG. 10 is an enlarged cross-sectional view of portion Q4 of FIG. 9. FIG. 11 is a cross-sectional view illustrating a modified example of the structure shown in FIG. 10. FIG. 12 is a cross-sectional view of a display device according to one embodiment taken along line X3-X3' of FIG. 8.

Referring further to FIGS. 9 to 12 in addition to FIGS. 1 to 8, the display device 1 includes the display substrate 10 and the color conversion substrate 30 as described above, and may further include the filler 70 positioned between the display substrate 10 and the color conversion substrate 30.

Hereinafter, the display substrate 10 will be described.

A first base portion 110 may be made of a light transmissive material. In some embodiments, the first base portion 110 may be a glass substrate or a plastic substrate. When the first base portion 110 is a plastic substrate, the first base portion 110 may have flexibility.

As described above, in some embodiments, the plurality of emission areas LA1, LA2, and LA3 and the non-emission area NLA may be defined in the first base portion 110 in the display area DA.

In some embodiments, the first side L1, the second side L2, the third side L3, and the fourth side L4 of the display device 1 may be the same as the four sides of the first base portion 110. That is, the first side L1, the second side L2, the third side L3, and the fourth side L4 of the display device 1 may be referred to as the first side L1, the second side L2, the third side L3, and the fourth side L4 of the first base portion 110.

A first conductive layer may be disposed on the first base portion 110. The first conductive layer may include a lower light blocking layer BML and a second signal line WR2. The lower light blocking layer BML may block external light or light from the light emitting element from flowing into a semiconductor layer ACT to be described later, thereby preventing or reducing a leakage current caused by light in the thin film transistors T1, T2, and T3 (see FIG. 3).

In some embodiments, the first conductive layer may be made of a material that blocks light and has conductivity. For example, the first conductive layer may include a single material of metal such as silver (Ag), nickel (Ni), gold (Au), platinum (Pt), aluminium (Al), copper (Cu), molybdenum (Mo), titanium (Ti), or neodymium (Nd), or an alloy thereof. In some embodiments, the first conductive layer may have a single-layer or multilayer structure. For example, when the first conductive layer has a multilayer structure, it may have a stacked structure of titanium (Ti)/copper (Cu)/indium tin oxide (ITO), or a stacked structure of titanium (Ti)/copper (Cu)/aluminium oxide (Al₂O₃), but is not limited thereto.

In some embodiments, a plurality of lower light blocking layers BML may be provided to respectively correspond to the semiconductor layers ACT and may overlap the semiconductor layers ACT. In some embodiments, the width of the lower light blocking layer BML may be greater than the width of the semiconductor layer ACT. The lower light blocking layer BML may be connected to anode electrodes AE1, AE2, and AE3 to be described later.

The second signal line WR2 may be connected to each of the signal lines WR1 and WR3 to be described later. In one embodiment, the second signal line WR2 may overlap the sealing area SA and may be disposed to overlap the sealing member 50. Each of first and third signal lines WR1 and WR3 to be described later may not overlap the sealing member 50.

A buffer layer 111 may be further disposed on the first conductive layer. The buffer layer 111 may be disposed on the first base portion 110 in the display area DA and the non-display area NDA. The buffer layer 111 may block foreign substances or moisture penetrating through the first base portion 110. For example, the buffer layer 111 may include an inorganic material such as SiO₂, SiNx, or SiON, and may be formed into a single layer or multiple layers.

The semiconductor layer ACT may be positioned on the buffer layer 111. In some embodiments, the semiconductor layer ACT may be disposed to correspond to each of the first emission area LA1, the second emission area LA2, and the third emission area LA3 in the display area DA.

In some embodiments, the semiconductor layer ACT may include an oxide semiconductor. For example, the semiconductor layer ACT may be formed of a Zn oxide-based material, e.g., Zn oxide, In-Zn oxide, or Ga-In-Zn oxide, and may also be an In-Ga-Zn-O (IGZO) semiconductor containing a metal such as indium (In) or gallium (Ga). However, the present disclosure is not limited thereto, and the semiconductor layer ACT may include amorphous silicon, polysilicon, or the like.

In some embodiments, the semiconductor layer ACT may be disposed to overlap the lower light blocking layer BML, thereby suppressing generation of a photocurrent in the semiconductor layer ACT.

A gate insulating layer 115 may be positioned on the semiconductor layer ACT. In some embodiments, the gate insulating layer 115 may be positioned in the display area DA and the non-display area NDA. In some embodiments, the gate insulating layer 115 may be disposed to correspond to electrodes of a second conductive layer to be described later. That is, the gate insulating layer 115 may be disposed only in a region overlapping the electrodes of the second conductive layer. However, the present disclosure is not limited thereto, and the gate insulating layer 115 may be formed entirely regardless of the arrangement of the electrodes of the second conductive layer. The gate insulating layer 115 may include an inorganic material such as SiO₂, SiNx, SiON, Al₂O₃, TiO₂, Ta₂O, HfO₂, or ZrO₂.

The second conductive layer may be disposed on the gate insulating layer 115. The second conductive layer may include gate electrodes GE of the thin film transistors T1, T2, and T3, a first pad electrode PD1 of the pad electrode PD, and the signal lines WR1 and WR3.

The gate electrode GE may be disposed in the display area DA to overlap the semiconductor layer ACT. The first pad electrode PD1 may be disposed in the non-display area NDA and may be positioned outside the sealing area SA in plan view. The first signal line WR1 may be connected to the first pad electrode PD1. That is, an outer end (in an outward direction of the sealing area SA) of the first signal line WR1 may be directly connected to the first pad electrode PD1. The first signal line WR1 may be disposed in the non-display area NDA and may be positioned outside the sealing area SA in plan view. The third signal line WR3 may be disposed in the non-display area NDA and may be positioned inside the sealing area SA in plan view. The first pad electrode PD1 may be connected to a second pad electrode PD2 of the pad electrode PD, the first signal line WR1 may be connected to the second signal line WR2 through a first connection electrode CNE1, and the third signal line WR3 may be connected to the second signal line WR2 through a second connection electrode CNE2.

The second conductive layer may include one or more materials of aluminium (Al), platinum (Pt), palladium (Pd), silver (Ag), magnesium (Mg), gold (Au), nickel (Ni), neodymium (Nd), iridium (Ir), chromium (Cr), lithium (Li), calcium (Ca), molybdenum (Mo), titanium (Ti), tungsten (W), and copper (Cu) in consideration of adhesion with an adjacent layer, surface flatness of a stacked layer, processability, and the like, and may be formed into a single layer or multiple layers.

A passivation layer 117 may be positioned on the second conductive layer. The passivation layer 117 may be positioned in the display area DA and the non-display area NDA. The passivation layer 117 may protect the components PD1, WR1, WR3, and GE of the first conductive layer therebelow.

In some embodiments, the passivation layer 117 may include an inorganic material. For example, the passivation layer 117 may include the inorganic material exemplified in the description of the first insulating layer 113. However, the present disclosure is not limited thereto, and the passivation layer 117 may include an organic material. A top surface 117u of the passivation layer 117 may be defined, and the passivation layer 117 may have a predetermined thickness t117. In some embodiments, since the passivation layer 117 includes an inorganic material, unlike the illustrated example, it may be formed to have a substantially uniform thickness t117 over the entire region.

A via layer 130 may be disposed on the passivation layer 117. The via layer 130 may cover the thin film transistors T1, T2, and T3 in the display area DA. In some embodiments, the via layer 130 may be a planarization layer. In some embodiments, the via layer 130 may be formed of an organic material. For example, the via layer 130 may include acrylic resin, epoxy resin, imide resin, ester resin, or the like. In some embodiments, the via layer 130 may include a photosensitive organic material.

A third conductive layer may be disposed on the via layer 130 in the display area DA. The third conductive layer may include the anode electrodes AE1, AE2, and AE3, connection electrodes CNE1, CNE2, and CNE3, and the second pad electrode PD2. The anode electrodes AE1, AE2, and AE3 may include a first anode electrode AE1, a second anode electrode AE2, and a third anode electrode AE3. Each of the anode electrodes AE1, AE2, and AE3 may be connected to the lower light blocking layer BML through a contact hole penetrating the via layer 130, the passivation layer 117, and the buffer layer 111, and may be connected to the semiconductor layer ACT through a contact hole penetrating the via layer 130 and the passivation layer 117. Meanwhile, the semiconductor layer ACT may include a channel region overlapping the gate electrode GE, a source region on one side of the channel region, and a drain region on the other side of the channel region, and each of the anode electrodes AE1, AE2, and AE3 may be connected to the drain region or the source region of the semiconductor layer ACT through a contact hole penetrating the via layer 130 and the passivation layer 117.

The first anode electrode AE1 may overlap the first emission area LA1 and may at least partially extend to the non-emission area NLA. The second anode electrode AE2 may overlap the second emission area LA2 and may at least partially extend to the non-emission area NLA, and the third anode electrode AE3 may overlap the third emission area LA3 and may at least partially extend to the non-emission area NLA.

The connection electrodes CNE1, CNE2, and CNE3 may include a first connection electrode CNE1, a second connection electrode CNE2, and a third connection electrode CNE3. The first connection electrode CNE1 may overlap each of the first signal line WR1 and the second signal line WR2. The first connection electrode CNE1 may be connected to the first signal line WR1 through a second contact hole CNT2 penetrating the via layer 130 and the passivation layer 117, and may be connected to the second signal line WR2 through a third contact hole CNT3 penetrating the via layer 130, the passivation layer 117, and the buffer layer 111. The second connection electrode CNE2 may overlap each of the second signal line WR2 and the third signal line WR3. The second connection electrode CNE2 may be connected to the third signal line WR3 through a fifth contact hole CNT5 penetrating the via layer 130 and the passivation layer 117, and may be connected to the second signal line WR2 through a fourth contact hole CNT4 penetrating the via layer 117, the passivation layer 117, and the buffer layer 111. The third signal line WR3 may be electrically connected to the light emitting elements ED1, ED2, and ED3. In one embodiment, since the pad electrode PD is exemplified as the second power pad electrode, the signal lines WR1, WR2, and WR3 connected to the pad electrode PD may be the second voltage line VL2 that provides the second power voltage applied to the pad electrode PD to the light emitting elements ED1, ED2, and ED3. To this end, the third signal line WR3 may be connected to the light emitting elements ED1, ED2, and ED3 through the third connection electrode CNE3. The third connection electrode CNE3 may be connected to the third signal line WR3 through a contact hole penetrating the via layer 130 and the passivation layer 117. The third connection electrode CNE3 may be connected to a cathode electrode CE to be described later. In FIG. 12, it is illustrated that a connection between the cathode electrode CE and the third connection electrode CNE3 and a connection between the third connection electrode CNE3 and the third signal line WR3 are formed in the non-display area NDA, but the present disclosure is not limited thereto, and they may be formed in the display area DA.

In some embodiments, the third conductive layer may be a reflective electrode, in which case the third conductive layer may be a metal layer containing a metal such as Ag, Mg, Al, Pt, Pd, Au, Ni, Nd, Ir, or Cr. In another embodiment, the third conductive layer may further include a metal oxide layer stacked on the metal layer. In an embodiment, the third conductive layer may have a multilayer structure, e.g., a two-layer structure of ITO/Ag, Ag/ITO, ITO/Mg, or ITO/MgF, or a three-layer structure such as ITO/Ag/ITO. When the third conductive layer includes a reflective electrode, as will be described later, part of external light incident from the outside of the display device 1 may be reflected from the electrodes of the third conductive layer.

A bank layer 150 may be positioned on the third conductive layer. The bank layer 150 may include an opening exposing the first anode electrode AE1, an opening exposing the second anode electrode AE2, and an opening exposing the third anode electrode AE3, and may define the first emission area LA1, the second emission area LA2, the third emission area LA3, and the non-emission area NLA. That is, a region of the first anode electrode AE1 that is exposed without being covered by the bank layer 150 may be the first emission area LA1. Similarly, a region of the second anode electrode AE2 that is exposed without being covered by the bank layer 150 may be the second emission area LA2, and a region of the third anode electrode AE3 that is exposed without being covered by the bank layer 150 may be the third emission area LA3. In addition, a region in which the bank layer 150 is positioned may be the non-emission area NLA.

Further, the bank layer 150 may expose the top surface of the second pad electrode PD2. Since the top surface of the second pad electrode PD2 is exposed by the bank layer 150, although not shown, the second pad electrode PD2 may be connected to the flexible circuit board FPC of FIG. 2.

In one embodiment, the via layer 130 and the bank layer 150 may include open portions OPa and OPb passing therethrough in a thickness direction, respectively. The open portions OPa and OPb may overlap the sealing area SA and may be disposed to overlap the sealing member 50. The top surface 117u of the passivation layer 117 may be exposed through a first open portion OPa, and the sealing member 50 may be in direct contact with the exposed top surface 117u of the passivation layer 117.

In some embodiments, the bank layer 150 may include an organic insulating material selected from the group consisting of acrylic resin, epoxy resin, phenolic resin, polyamide resin, polyimide resin, unsaturated polyester resin, polyphenylene resin, polyphenylenesulfide resin and benzocyclobutene (BCB).

In some embodiments, the bank layer 150 may overlap a light blocking pattern 250 to be described later. In addition, in some embodiments, the bank layer 150 may also overlap a bank pattern 370 to be described later.

As shown in FIGS. 9 and 12, a light emitting layer OL may be positioned on the first anode electrode AE1, the second anode electrode AE2, and the third anode electrode AE3.

In some embodiments, the light emitting layer OL may have a shape of a continuous layer formed over the plurality of emission areas LA1, LA2, and LA3 and the non-emission area NLA. Although it is illustrated in the drawings that the light emitting layer OL is positioned only in the display area DA, the present disclosure is not limited thereto. In some other embodiments, the light emitting layer OL may be partially positioned in the non-display area NDA. A more detailed description of the light emitting layer OL will be given later.

A cathode electrode CE may be located on the light emitting layer OL. The cathode electrode CE may be partially positioned in the non-display area NDA.

In some embodiments, the cathode electrode CE may have a semi-transmissive or transmissive property. When the cathode electrode CE has a semi-transmissive property, the cathode electrode CE may include Ag, Mg, Cu, Al, Pt, Pd, Au, Ni, Nd, Ir, Cr, Li, Ca, LiF/Ca, LiF/Al, Mo, Ti or a compound or mixture thereof, such as a mixture of Ag and Mg. In addition, when the cathode electrode CE has a thickness of tens to hundreds of angstroms, the cathode electrode CE may have a semi-transmissive property.

When the cathode electrode CE has a transmissive property, the cathode electrode CE may include a transparent conductive oxide (TCO). For example, the cathode electrode CE may include tungsten oxide (WxOx), titanium oxide (TiO₂), indium tin oxide (ITO), indium zinc oxide (IZO), zinc oxide (ZnO), indium tin zinc oxide (ITZO), magnesium oxide (MgO) or the like.

In some embodiments, the cathode electrode CE may completely cover the light emitting layer OL. In some embodiments, as shown in FIG. 12, the end of the cathode electrode CE may be located relatively more outward than the end of the light emitting layer OL, and the end of the light emitting layer OL may be completely covered with the cathode electrode CE.

The first anode electrode AE1, the light emitting layer OL and the cathode electrode CE may constitute a first light emitting element ED1. The second anode electrode AE2, the light emitting layer OL and the cathode electrode CE may constitute a second light emitting element ED2. The third anode electrode AE3, the light emitting layer OL and the cathode electrode CE may constitute a third light emitting element ED3. Each of the first light emitting element ED1, the second light emitting element ED2, and the third light emitting element ED3 may emit emission light LE.

As shown in FIG. 10, the emission light LE finally emitted from the light emitting layer OL may be mixed light in which a first component LE1 and a second component LE2 are mixed. Each of the first component LE1 and the second component LE2 of the emission light LE may have a peak wavelength of 440 nm or more and less than 480 nm. That is, the emission light LE may be blue light.

As shown in FIG. 10, in some embodiments, the light emitting layer OL may have a structure, e.g., a tandem structure, in which a plurality of light emitting layers are disposed to overlap each other. For example, the light emitting layer OL may include a first stack ST1 including a first light emitting layer EML1, a second stack ST2 positioned on the first stack ST1 and including a second light emitting layer EML2, a third stack ST3 positioned on the second stack ST2 and including a third light emitting layer EML3, a first charge generation layer CGL1 positioned between the first stack ST1 and the second stack ST2, and a second charge generation layer CGL2 positioned between the second stack ST2 and the third stack ST3. The first stack ST1, the second stack ST2, and the third stack ST3 may be disposed to overlap each other.

The first light emitting layer EML1, the second light emitting layer EML2, and the third light emitting layer EML3 may be disposed to overlap each other.

In some embodiments, all of the first light emitting layer EML1, the second light emitting layer EML2, and the third light emitting layer EML3 may emit light of the blue wavelength light. For example, each of the first light emitting layer EML1, the second light emitting layer EML2, and the third light emitting layer EML3 may be a blue light emitting layer and may include an organic material.

In some embodiments, at least one of the first light emitting layer EML1, the second light emitting layer EML2, and the third light emitting layer EML3 may emit first blue light having a first peak wavelength, and at least another one of thereof may emit second blue light having a second peak wavelength different from the first peak wavelength. For example, any one of the first light emitting layer EML1, the second light emitting layer EML2, and the third light emitting layer EML3 may emit the first blue light having the first peak wavelength, and the other two thereof may emit the second blue light having the second peak wavelength. That is, the emission light LE finally emitted from the light emitting layer OL may be mixed light in which the first component LE1 and the second component LE2 are mixed, the first component LE1 may be the first blue light having the first peak wavelength, and the second component LE2 may be the second blue light having the second peak wavelength.

In some embodiments, one of the first peak wavelength and the second peak wavelength may be in a range of 440 nm or more and less than 460 nm, and the other one thereof may be in a range of 460 nm or more and 480 nm or less. However, the range of the first peak wavelength and the range of the second peak wavelength are not limited thereto. For example, the range of the first peak wavelength and the range of the second peak wavelength may both include 460 nm. In some embodiments, one of the first blue light and the second blue light may be light of a deep blue color, and the other one thereof may be light of a sky blue color.

According to some embodiments, the emission light LE emitted from the light emitting layer OL may be blue light and may include a long wavelength component and a short wavelength component. Therefore, ultimately, the light emitting layer OL may emit blue light having an emission peak in a broader wavelength range, as the emission light LE. Through this, there is an advantage in that color visibility can be improved at a side viewing angle compared to a conventional light emitting element that emits blue light having a sharp emission peak.

In some embodiments, each of the first light emitting layer EML1, the second light emitting layer EML2, and the third light emitting layer EML3 may include a host and a dopant. A material of the host is not particularly limited as long as it is generally used. For example, tris(8-hydroxyquinolinato)aluminium (Alq3), 4,4'-bis(N-carbazolyl)-1,1'-biphenyl (CBP), poly(n-vinylcarbazole) (PVK), 9,10-di(naphthalene-2-yl)anthracene (ADN), 4,4',4"-Tris(carbazol-9-yl)-triphenylamine (TCTA), 1,3,5-tris(N-phenylbenzimidazole-2-yl)benzene (TPBi), 3-tert-butyl-9,10-di(naphth-2-yl)anthracene (TBADN), distyrylarylene (DSA), 4,4'-bis(9-carbazolyl)-2,2'-dimethyl-biphenyl (CDBP), or 2-methyl-9,10-bis(naphthalen-2-yl)anthracene (MADN), and the like may be used.

The first light emitting layer EML1, the second light emitting layer EML2, and the third light emitting layer EML3 that emit blue light may each include a fluorescent material containing any one selected from the group consisting of, e.g., spiro-DPVBi, spiro-6P, distyryl-benzene (DSB), distyryl-arylene (DSA), polyfluorene (PFO)-based polymer, and poly(p-phenylene vinylene) (PPV)-based polymer. As another example, a phosphorescent material containing an organometallic complex such as (4,6-F2ppy)2Irpic may be included.

As described above, at least one of the first light emitting layer EML1, the second light emitting layer EML2, and the third light emitting layer EML3 emits blue light in a wavelength band different from that of at least another one thereof. In order to emit blue light in different wavelength bands, the first light emitting layer EML1, the second light emitting layer EML2, and the third light emitting layer EML3 may include the same material, and a method of adjusting a resonance distance may be used. Alternatively, in order to emit blue light in different wavelength ranges, at least one of the first light emitting layer EML1, the second light emitting layer EML2, and the third light emitting layer EML3, and at least another one of the first light emitting layer EML1, the second light emitting layer EML2, and the third light emitting layer EML3 may include different materials from each other.

However, the present disclosure is not limited thereto. The blue light emitted from each of the first light emitting layer EML1, the second light emitting layer EML2, and the third light emitting layer EML3 may have a peak wavelength of 440 nm to 480 nm, and may be made of the same material.

Alternatively, in still another embodiment, at least one of the first light emitting layer EML1, the second light emitting layer EML2, and the third light emitting layer EML3 may emit first blue light having a first peak wavelength, another one thereof may emit second blue light having a second peak wavelength different from the first peak wavelength, and the remaining one thereof may emit third blue light having a third peak wavelength different from the first peak wavelength and the second peak wavelength. In some other embodiments, any one of the first peak wavelength, the second peak wavelength, and the third peak wavelength may be in a range of 440 nm or more and less than 460 nm. Another one of the first peak wavelength, the second peak wavelength, and the third peak wavelength may be in a range of 460 nm or more and less than 470 nm, and the remaining one thereof may be in a range of 470 nm or more and 480 nm or less.

According to still some other embodiments, the emission light LE emitted from the light emitting layer OL is blue light and includes a long wavelength component, an intermediate wavelength component, and a short wavelength component. Therefore, ultimately, the light emitting layer OL may emit blue light having an emission peak in a broader wavelength range as the emission light LE, thereby improving the color visibility at a side viewing angle.

According to the above-described embodiments, compared to a conventional light emitting element that does not employ a tandem structure, i.e., a structure in which a plurality of light emitting layers are stacked, there is an advantage in that the light efficiency is increased and the lifespan of the display device can be improved.

Alternatively, in still some other embodiments, at least one of the first light emitting layer EML1, the second light emitting layer EML2, and the third light emitting layer EML3 may emit light of the third color, e.g., blue light, and at least another one thereof may emit light of the green wavelength light. In still some other embodiments, the peak wavelength of the blue light emitted from at least one of the first light emitting layer EML1, the second light emitting layer EML2, and the third light emitting layer EML3 may be in a range of 440 nm or more and 480 nm or less, or in a range of 460 nm or more and 480 nm or less. The green light emitted from at least another one of the first light emitting layer EML1, the second light emitting layer EML2, and the third light emitting layer EML3 may have a peak wavelength in a range of 510 nm to 550 nm.

For example, any one of the first light emitting layer EML1, the second light emitting layer EML2, and the third light emitting layer EML3 may be a green light emitting layer that emits green light, and the other two thereof may be blue light emitting layers that emit blue light. When the other two of the first light emitting layer EML1, the second light emitting layer EML2, and the third light emitting layer EML3 are blue light emitting layers, the blue light emitted from the two blue light emitting layers may have the same peak wavelength range, or may have different peak wavelength ranges.

According to still some other embodiments, the emission light LE emitted from the light emitting layer OL may be mixed light in which the first component LE1 that is blue light and the second component LE2 that is green light are mixed. For example, when the first component LE1 is dark blue light and the second component LE2 is green light, the emission light LE may have a sky blue color. Similarly to the above-described embodiments, the emission light LE emitted from the light emitting layer OL is mixed light of blue light and green light, and includes a long wavelength component and a short wavelength component. Therefore, ultimately, the light emitting layer OL may emit blue light having an emission peak in a broader wavelength range as the emission light LE, thereby improving the color visibility at a side viewing angle. In addition, since the second component LE2 of the emission light LE is green light, the green light component of the light provided from the display device 1 to the outside may be supplemented, thereby improving the color reproducibility of the display device 1.

In still some other embodiments, a green light emitting layer among the first light emitting layer EML1, the second light emitting layer EML2, and the third light emitting layer EML3 may include a host and a dopant. A material of the host including the green light emitting layer is not particularly limited as long as it is generally used. For example, tris(8-hydroxyquinolinato)aluminium (Alq3), 4,4'-bis(N-carbazolyl)-1,1'-biphenyl (CBP), poly(n-vinylcarbazole) (PVK), 9,10-di(naphthalene-2-yl)anthracene (ADN), 4,4',4"-Tris(carbazol-9-yl)-triphenylamine (TCTA), 1,3,5-tris(N-phenylbenzimidazole-2-yl)benzene (TPBi), 3-tert-butyl-9,10-di(naphth-2-yl)anthracene (TBADN), distyrylarylene (DSA), 4,4'-bis(9-carbazolyl)-2,2'-dimethyl-biphenyl (CDBP), or 2-methyl-9,10-bis(naphthalen-2-yl)anthracene (MADN), and the like may be used.

The dopant included in the green light emitting layer may include a fluorescent material containing, for example, tris(8-hydroxyquinolinato)aluminium(III) (Alq3), or a phosphorescent material such as fac tris(2-phenylpyridine)iridium (Ir(ppy)3), bis(2-phenylpyridine)(acetylacetonate)iridium(III) (Ir(ppy)2(acac)), and 2-phenyl-4-methylpyridine iridium (Ir(mpyp)3).

The first charge generation layer CGL1 may be positioned between the first stack ST1 and the second stack ST2. The first charge generation layer CGL1 may serve to allow electric charge to be injected into each light emitting layer. The first charge generation layer CGL1 may serve to control charge balance between the first stack ST1 and the second stack ST2. The first charge generation layer CGL1 may include an n-type charge generation layer CGL11 and a p-type charge generation layer CGL12. The p-type charge generation layer CGL12 may be disposed on the n-type charge generation layer CGL11, and between the n-type charge generation layer CGL11 and the second stack ST2.

The first charge generation layer CGL1 may have a structure in which the n-type charge generation layer CGL11 and the p-type charge generation layer CGL12 are in contact with each other. The n-type charge generation layer CGL11 is disposed closer to the anode electrodes AE1, AE2, and AE3 than the cathode electrode CE. The p-type charge generation layer CGL12 is disposed closer to the cathode electrode CE than the anode electrodes AE1, AE2, and AE3. The n-type charge generation layer CGL11 supplies electrons to the first light emitting layer EML1 adjacent to the anode electrodes AE1, AE2, and AE3, and the p-type charge generation layer CGL12 supplies holes to the second light emitting layer EML2 included in the second stack ST2. The first charge generation layer CGL1 is disposed between the first stack ST1 and the second stack ST2 to provide electric charge to each light emitting layer, thereby increasing light emission efficiency and decreasing a driving voltage.

The first stack ST1 may be positioned on the first anode electrode AE1, the second anode electrode AE2, and the third anode electrode AE3, and may further include a first hole transport layer HTL1, a first electron block layer BIL1, and a first electron transport layer ETL1.

The first hole transport layer HTL1 may be positioned on the first anode electrode AE1, the second anode electrode AE2, and the third anode electrode AE3. The first hole transport layer HTL1 serves to facilitate the transport of holes and may include a hole transport material. The hole transport material may include a carbazole-based derivative such as N-phenylcarbazole or polyvinylcarbazole, a fluorene-based derivative, a triphenylamine-based derivative such as N,N'-bis(3-methylphenyl)-N,N'-diphenyl-[1,1-biphenyl]-4,4'-diamine (TPD) or 4,4',4"-tris(N-carbazolyl)triphenylamine (TCTA), N,N'-di(1-naphthyl)-N,N'-diphenylbenzidine (NPB), 4,4'-Cyclohexylidenebis[N,N-bis(4-methylphenyl)benzenamine] (TAPC), or the like, but is not limited thereto.

The first electron block layer BIL1 may be positioned on the first hole transport layer HTL1, and between the first hole transport layer HTL1 and the first light emitting layer EML1. The first electron block layer BIL1 may include a hole transport material and a metal or metal compound to prevent electrons generated in the first light emitting layer EML1 from moving into the first hole transport layer HTL1. In some embodiments, the first hole transport layer HTL1 and the first electron block layer BIL1 described above may also be formed of a single layer in which respective materials are mixed.

The first electron transport layer ETL1 may be positioned on the first light emitting layer EML1, and between the first charge generation layer CGL1 and the first light emitting layer EML1. In some embodiments, the first electron transport layer ETL1 may include an electron transport material such as Tris(8-hydroxyquinolinato)aluminum (Alq3), 1,3,5-Tri(1-phenyl-1H-benzo[d]imidazol-2-yl)phenyl (TPBi), 2,9-Dimethyl-4,7-diphenyl-1,10-phenanthroline (BCP), 4,7-Diphenyl-1,10-phenanthroline (Bphen), 3-(4-Biphenylyl)-4-phenyl-5-tert-butylphenyl-1,2,4-triazole (TAZ), 4-(Naphthalen-1-yl)-3,5-diphenyl-4H-1,2,4-triazole (NTAZ), 2-(4-Biphenylyl)-5-(4-tert-butylphenyl)-1,3,4-oxadiazole (tBu-PBD), Bis(2-methyl-8-quinolinolato-N1,08)-(1,1'-Biphenyl-4-olato)aluminum (BAlq), berylliumbis(benzoquinolin-10-olate (Bebq2), 9,10-di(naphthalene-2-yl)anthracene (ADN), or a mixture thereof. However, the present disclosure is not limited to the above types of the electron transport material. The second stack ST2 may be positioned on the first charge generation layer CGL1, and further include a second hole transport layer HTL2, a second electron block layer BIL2, and a second electron transport layer ETL2.

The second hole transport layer HTL2 may be positioned on the first charge generation layer CGL1. The second hole transport layer HTL2 may be made of the same material as the first hole transport layer HTL1, or may include one or more materials selected from examples of materials included in the first hole transport layer HTL1. The second hole transport layer HTL2 may be formed of a single layer or a plurality of layers.

The second electron block layer BIL2 may be positioned on the second hole transport layer HTL2, and between the second hole transport layer HTL2 and the light emitting layer EML2. The second electron block layer BIL2 may be formed of the same material and the same structure as the first electron block layer BIL1, or may include one or more materials selected from examples of materials included in the first electron block layer BIL1.

The second electron transport layer ETL2 may be positioned on the second light emitting layer EML2, and between the second charge generation layer CGL2 and the second light emitting layer EML2. The second electron transport layer ETL2 may be formed of the same material and the same structure as the first electron transport layer ETL1, or may include one or more materials selected from examples of materials included in the first electron transport layer ETL1. The second electron transport layer ETL2 may be formed of a single layer or a plurality of layers.

The second charge generation layer CGL2 may be positioned on the second stack ST2 and between the second stack ST2 and the third stack ST3.

The second charge generation layer CGL2 may have the same structure as the first charge generation layer CGL1 described above. For example, the second charge generation layer CGL2 may include an n-type charge generation layer CGL21 disposed closer to the second stack ST2 and a p-type charge generation layer CGL22 disposed closer to the cathode electrode CE. The p-type charge generation layer CGL22 may be disposed on the n-type charge generation layer CGL21.

The second charge generation layer CGL2 may have a structure in which the n-type charge generation layer CGL21 and the p-type charge generation layer CGL22 are in contact with each other. The first charge generation layer CGL1 and the second charge generation layer CGL2 may be made of different materials, or may be made of the same material.

The third stack ST3 may be positioned on the second charge generation layer CGL2, and may further include a third hole transport layer HTL3 and a third electron transport layer ETL3.

The third hole transport layer HTL3 may be positioned on the second charge generation layer CGL2. The third hole transport layer HTL3 may be made of the same material as the first hole transport layer HTL1, or may include one or more materials selected from examples of materials included in the first hole transport layer HTL1. The third hole transport layer HTL3 may be formed of a single layer or a plurality of layers. When the third hole transport layer HTL3 is formed of a plurality of layers, each layer may include a different material.

The third electron transport layer ETL3 may be positioned on the third light emitting layer EML3, and between the cathode electrode CE and the third light emitting layer EML3. The third electron transport layer ETL3 may be formed of the same material and the same structure as the first electron transport layer ETL1, or may include one or more materials selected from examples of materials included in the first electron transport layer ETL1. The third electron transport layer ETL3 may be formed of a single layer or a plurality of layers. When the third electron transport layer ETL3 is formed of a plurality of layers, each layer may include a different material.

Although not shown in the drawings, a hole injection layer may be further positioned at least one of between the first stack ST1 and the first anode electrode AE1, the second anode electrode AE2 and the third anode electrode AE3, between the second stack ST2 and the first charge generation layer CGL1, and between the third stack ST3 and the second charge generation layer CGL2. The hole injection layer may serve to allow holes to be more smoothly injected into the first light emitting layer EML1, the second light emitting layer EML2, and the third light emitting layer EML3. In some embodiments, the hole injection layer may be formed of one or more selected from the group consisting of cupper phthalocyanine (CuPc), poly(3,4)-ethylenedioxythiophene (PEDOT), polyaniline (PANI), and N,N-dinaphthyl-N,N'-diphenyl benzidine (NPD), but is not limited thereto. In some embodiments, the hole injection layer may be positioned between the first stack ST1 and the first anode electrode AE1, the second anode electrode AE2 and the third anode electrode AE3, between the second stack ST2 and the first charge generation layer CGL1, and between the third stack ST3 and the second charge generation layer CGL2.

Although not shown in the drawings, an electron injection layer may be further positioned at least one of between the third electron transport layer ETL3 and the cathode electrode CE, between the second charge generation layer CGL2 and the second stack ST2, and between the first charge generation layer CGL1 and the first stack ST1. The electron injection layer may serve to facilitate electron injection, and may use tris(8-hydroxyquinolino)aluminum (Alq3), PBD, TAZ, spiro-PBD, BAlq, or SAlq, but is not limited thereto. In addition, the electron injection layer may be a metal halide compound, for example, may be any one or more selected from the group consisting of MgF₂, LiF, NaF, KF, RbF, CsF, FrF, LiI, NaI, KI, RbI, CsI, FrI, and CaF2, but is not limited thereto. In addition, the electron injection layer may include a lanthanide-based material such as Yb, Sm, or Eu. Alternatively, the electron injection layer may include both a metal halide material and a lanthanide-based material, such as RbI:Yb or KI:Yb. When the electron injection layer includes both a metal halide material and a lanthanide-based material, the electron injection layer may be formed by co-depositing the metal halide material and the lanthanide-based material. In some embodiments, the electron injection layer may be positioned between the third electron transport layer ETL3 and the cathode electrode CE, between the second charge generation layer CGL2 and the second stack ST2, and between the first charge generation layer CGL1 and the first stack ST1.

In addition to the above-described structure, the structure of the light emitting layer OL may be modified. For example, the light emitting layer OL may be modified into a light emitting layer OLa shown in FIG. 11. Unlike the structure shown in FIG. 10, the light emitting layer OLa shown in FIG. 11 may further include a fourth stack ST4 on the third stack ST3, and a third charge generation layer CGL3 positioned between the third stack ST3 and the fourth stack ST4.

The fourth stack ST4 may include a fourth light emitting layer EML4, and may further include a fourth hole transport layer HTL4 and a fourth electron transport layer ETL4.

The first light emitting layer EML1, the second light emitting layer EML2, the third light emitting layer EML3, and the fourth light emitting layer EML4 included in the light emitting layer OLa may each emit light of the blue wavelength light. At least one of the first light emitting layer EML1, the second light emitting layer EML2, the third light emitting layer EML3, and the fourth light emitting layer EML4, and at least another one thereof may emit blue light having different peak wavelength ranges.

Alternatively, at least one of the first light emitting layer EML1, the second light emitting layer EML2, the third light emitting layer EML3, and the fourth light emitting layer EML4 may emit green light, and at least another one thereof may emit blue light. For example, any one of the first light emitting layer EML1, the second light emitting layer EML2, the third light emitting layer EML3, and the fourth light emitting layer EML4 may be a green light emitting layer, and the other three thereof may all be blue light emitting layers.

Alternatively, the fourth light emitting layer EML4 may be a green light emitting layer, and the first light emitting layer EML1, the second light emitting layer EML2, and the third light emitting layer EML3 may all be blue light emitting layers.

The fourth hole transport layer HTL4 may be positioned on the third charge generation layer CGL3. The fourth hole transport layer HTL4 may be made of the same material as the first hole transport layer HTL1, or may include one or more materials selected from examples of materials included in the first hole transport layer HTL1. The fourth hole transport layer HTL4 may be formed of a single layer or a plurality of layers. When the fourth hole transport layer HTL4 is formed of a plurality of layers, each layer may include a different material.

The third electron block layer BIL3 may be positioned on the third hole transport layer HTL3, and may be positioned between the third hole transport layer HTL3 and the fourth light emitting layer EML3. The third electron block layer BIL3 may be formed of the same material and the same structure as the first electron block layer BIL1, or may include one or more materials selected from examples of materials included in the first electron block layer BIL1. In some other embodiments, the third electron block layer BIL3 may be omitted.

The fourth electron transport layer ETL4 may be positioned on the fourth light emitting layer EML4, and may be positioned between the cathode electrode CE and the fourth light emitting layer EML4. The fourth electron transport layer ETL4 may be formed of the same material and the same structure as the first electron transport layer ETL1, or may include one or more materials selected from examples of materials included in the first electron transport layer ETL1. The fourth electron transport layer ETL4 may be formed of a single layer or a plurality of layers. When the fourth electron transport layer ETL4 is formed of a plurality of layers, each layer may include a different material.

The third charge generation layer CGL3 may have the same structure as the first charge generation layer CGL1 described above. For example, the third charge generation layer CGL3 may include an n-type charge generation layer CGL31 disposed closer to the second stack ST2 and a p-type charge generation layer CGL32 disposed closer to the cathode electrode CE. The p-type charge generation layer CGL32 may be disposed on the n-type charge generation layer CGL31.

Although not shown in the drawings, the electron injection layer may be further positioned between fourth electron transport layer ETL4 and cathode electrode CE. In addition, the hole injection layer may be further positioned between the fourth stack ST4 and the third charge generation layer CGL3.

In some embodiments, the light emitting layer OL shown in FIG. 10 and the light emitting layer OLa shown in FIG. 11 may not include a red light emitting layer in common, and thus may not emit light of the first color, e.g., red light. That is, the emission light LE may not include a light component having a peak wavelength of 610 nm to about 650 nm, but may include only a light component having a peak wavelength of 440 nm to 550 nm.

As shown in FIG. 12, the dam member DM may be positioned on the passivation layer 117 in the non-display area NDA. In plan view, the dam member DM may be positioned in the non-display area NDA between the sealing area SA and the display area DA.

In some embodiments, the dam member DM may include a plurality of dams. For example, the dam member DM may include a first dam D1 and a second dam D2.

The first dam D1 may partially overlap a power supply line VSL, and may be spaced apart from the via layer 130 with the power supply line VSL interposed therebetween. In some embodiments, the first dam D1 may include a first lower dam pattern D11 positioned on the passivation layer 117, and a first upper dam pattern D12 positioned on the first lower dam pattern D11.

The second dam D2 may be positioned outside the first dam D1 and may be spaced apart from the first dam D1. In some embodiments, the second dam D2 may include a second lower dam pattern D22 positioned on the passivation layer 117, and a second upper dam pattern D21 positioned on the second lower dam pattern D22.

In some embodiments, the first lower dam pattern D11 and the second lower dam pattern D21 may be made of the same material as the via layer 130 and may be formed simultaneously with the via layer 130.

In some embodiments, the first upper dam pattern D12 and the second upper dam pattern D22 may be made of the same material as the bank layer 150 and may be formed simultaneously with the bank layer 150.

In some embodiments, the heights of the first dam D1 and the second dam D2 may be different from each other. For example, the height of the second dam D2 may be greater than the height of the first dam D1. That is, as the distance from the display area DA increases, the height of the dam included in the dam member DM may gradually increase. Accordingly, in a process of forming an organic layer 173 included in an encapsulation layer 170 to be described later, it is possible to more effectively block the overflow of an organic material.

As shown in FIGS. 9 and 12, a first capping layer 160 may be positioned on the cathode electrode CE. The first capping layer 160 may be disposed in common in the first emission area LA1, the second emission area LA2, the third emission area LA3, and the non-emission area NLA, and may improve viewing angle characteristics and increase external luminous efficiency.

The first capping layer 160 may include at least one of an inorganic material and an organic material having light transmittance. That is, the first capping layer 160 may be formed of an inorganic layer, an organic layer, or an organic layer including inorganic particles. For example, the first capping layer 160 may include a triamine derivative, a carbazole biphenyl derivative, an arylenediamine derivative, an aluminium quinolium complex (Alq3), or the like.

In addition, the first capping layer 160 may be formed of a mixture of a high refractive material and a low refractive material. Alternatively, the first capping layer 160 may include two layers having different refractive indices, e.g., a high refractive index layer and a low refractive index layer.

In some embodiments, the first capping layer 160 may completely cover the cathode electrode CE.

The encapsulation layer 170 may be disposed on the first capping layer 160. The encapsulation layer 170 protects components, e.g., the light emitting elements ED1, ED2, and ED3, positioned under the encapsulation layer 170 from external foreign substances such as moisture. The encapsulation layer 170 is commonly disposed in the first emission area LA1, the second emission area LA2, the third emission area LA3, and the non-emission area NLA. In some embodiments, the encapsulation layer 170 may directly cover the cathode electrode CE. In some embodiments, a capping layer (not shown) that covers the cathode electrode CE may be further disposed between the encapsulation layer 170 and the cathode electrode CE. In this case, the encapsulation layer 170 may directly cover the capping layer. The encapsulation layer 170 may be a thin film encapsulation layer.

In some embodiments, the encapsulation layer 170 may include a lower inorganic layer 171, an organic layer 173, and an upper inorganic layer 175 sequentially stacked on the first capping layer 160.

In some embodiments, the lower inorganic layer 171 may cover the first light emitting element ED1, the second light emitting element ED2, and the third light emitting element ED3 in the display area DA. The lower inorganic layer 171 may cover the dam member DM in the non-display area NDA and may extend to the outside of the dam member DM.

In some embodiments, the lower inorganic layer 171 may completely cover the first capping layer 160. In some embodiments, the end of the lower inorganic layer 171 may be positioned relatively more outward than the end of the first capping layer 160, and the end of the first capping layer 160 may be completely covered with the lower inorganic layer 171.

The lower inorganic layer 171 may include a plurality of stacked films. The organic layer 173 may be positioned on the lower inorganic layer 171. The organic layer 173 may cover the first light emitting element ED1, the second light emitting element ED2, and the third light emitting element ED3 in the display area DA. In some embodiments, the organic layer 173 may be partially disposed in the non-display area NDA, but may not be disposed outside the dam member DM. The organic layer 173 is illustrated as being partially disposed more inward than the first dam D1, but is not limited thereto. In some other embodiments, a part of the organic layer 173 may be accommodated in a space between the first dam D1 and the second dam D2, and the end of the organic layer 173 may be positioned in a region between the first dam D1 and the second dam D2.

The upper inorganic layer 175 may be positioned on the organic layer 173. The upper inorganic layer 175 may cover the organic layer 173. In some embodiments, the upper inorganic layer 175 may be in direct contact with the lower inorganic layer 171 in the non-display area NDA to form an inorganic-inorganic junction. In some embodiments, the end of the upper inorganic layer 175 and the end of the lower inorganic layer 171 may be substantially aligned. The upper inorganic layer 175 may include a plurality of stacked layers.

In some embodiments, the lower inorganic layer 171 and the upper inorganic layer 175 may each be made of silicon nitride, aluminium nitride, zirconium nitride, titanium nitride, hafnium nitride, tantalum nitride, silicon oxide, aluminium oxide, titanium oxide, tin oxide, cerium oxide, silicon oxynitride (SiON), lithium fluoride, or the like.

In some embodiments, the organic layer 173 may be formed of acrylic resin, methacrylic resin, polyisoprene, vinyl resin, epoxy resin, urethane resin, cellulose resin, perylene resin or the like.

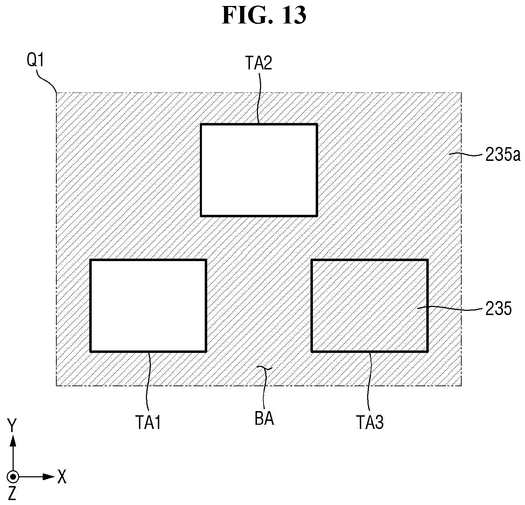

Hereinafter, the color conversion substrate 30 will be described with further reference to FIGS. 13 to 15 in addition to FIGS. 1 to 12.

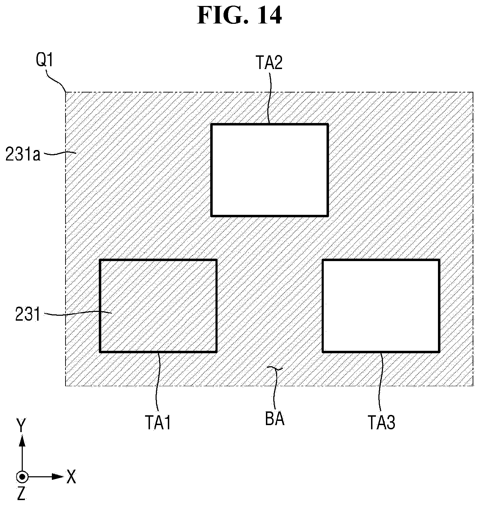

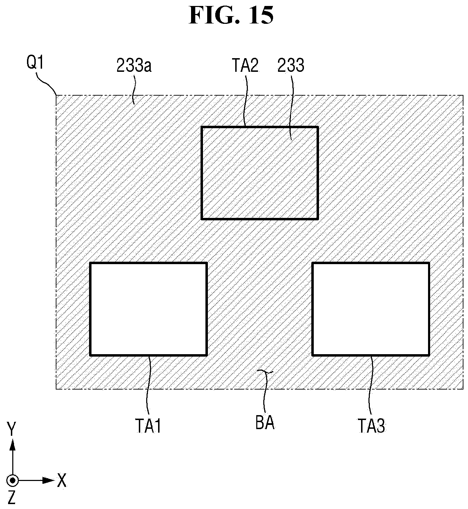

FIG. 13 is a plan view illustrating a schematic arrangement of a third color filter in a color conversion substrate of a display device according to one embodiment. FIG. 14 is a plan view illustrating a schematic arrangement of a first color filter in a color conversion substrate of a display device according to one embodiment. FIG. 15 is a plan view illustrating a schematic arrangement of a second color filter in a color conversion substrate of a display device according to one embodiment.

The second base portion 310 shown in FIGS. 9 and 12 may be made of a light transmitting material.

In some embodiments, the second base portion 310 may include a glass substrate or a plastic substrate. In some embodiments, the second base portion 310 may further include a separate layer, for example, an insulating layer such as an inorganic layer, located on the glass substrate or the plastic substrate.

As described above, in some embodiments, the plurality of light transmitting areas TA1, TA2, and TA3 and the light blocking area BA may be defined in the second base portion 310. When the second base portion 310 includes a glass substrate, the refractive index of the second base portion 310 may be about 1.5.

As shown in FIGS. 9 and 12, a color filter layer may be disposed on one surface of the second base portion 310 facing the display substrate 10. The color filter layer may include color filters 231, 233, and 235 and the light blocking pattern 250.

As shown in FIGS. 9, 12, and 13 to 15, the color filters 231, 233, and 235 may be disposed to overlap the light transmitting areas TA1, TA2, and TA3, respectively. The light blocking pattern 250 may be disposed to overlap the light blocking area BA. A first color filter 231 may overlap the first light transmitting area TA1, a second color filter 233 may overlap the second light transmitting area TA2, and a third color filter 235 may overlap the third light transmitting area TA3. The light blocking pattern 250 may be disposed to overlap the light blocking area BA to block light transmission. In some embodiments, the light blocking pattern 250 may be disposed in a substantially grid shape in plan view. In one embodiment, the light blocking pattern 250 may include a first light blocking pattern portion 235a on one surface of the second base portion 310, a second light blocking pattern portion 231a on the first light blocking pattern portion 235a, and a third light blocking pattern portion 233a on the second light blocking pattern portion 231a. The first light blocking pattern portion 235a may include the same material as the third color filter 235, the second light blocking pattern portion 231a may include the same material as the first color filter 231, and the third light blocking pattern portion 233a may include the same material as the second color filter 233. That is, the light blocking pattern 250 may include a structure in which the first light blocking pattern portion 235a, the second light blocking pattern portion 231a, and the third light blocking pattern portion 233a are sequentially stacked from one surface of the second base portion 310 in the light blocking area BA. In a case that the light blocking pattern 250 has a structure in which the first light blocking pattern portion 235a, the second light blocking pattern portion 231a, and the third light blocking pattern portion 233a are sequentially stacked from one surface of the second base portion 310 in the light blocking area BA, when external light La is incident into the light blocking area BA, as shown in FIG. 9, the light of the first color and the light of the second color excluding the light of the third color may all be absorbed by the first blocking pattern portion 235a while passing through the first light blocking pattern portion 235a, and the light of the third color may also be absorbed while passing through the second and third light blocking pattern portions 231a and 233a. However, although not shown, there may exist some light reflected to the outside at the interface between the first light blocking pattern portion 235a and the second base portion 310 without being transmitted by the first light blocking pattern portion 235a. The light in this case may be light of the third color.

In some other embodiments, the light blocking pattern 250 may include an organic light blocking material, and may be formed by coating and exposing the organic light blocking material. For example, the organic light blocking material may include a black matrix.

The first color filter 231 may function as a blocking filter that blocks blue light and green light. In some embodiments, the first color filter 231 may selectively transmit light of the first color (e.g., red light), and may block or absorb light of the second color (e.g., green light) and light of the third color (e.g., blue light)). For example, the first color filter 231 may be a red color filter and may include a red colorant. The first color filter 231 may include a base resin and a red colorant dispersed in the base resin.

The second color filter 233 may function as a blocking filter that blocks blue light and red light. In some embodiments, the second color filter 233 may selectively transmit light of the second color (e.g., green light), and may block or absorb light of the third color (e.g., blue light) and light of the first color (e.g., red light). For example, the second color filter 233 may be a green color filter and may include a green colorant.

The third color filter 235 may selectively transmit light of the third color (e.g., blue light), and may block or absorb light of the first color (e.g., red light) and light of the second color (e.g., green light). In some embodiments, the third color filter 235 may be a blue color filter, and may include a blue colorant such as a blue dye or a blue pigment. In the present disclosure, the colorant is a concept including both a dye and a pigment.

As shown in FIGS. 9 and 12, a low refractive index layer 391 may be provided to cover the light blocking pattern 250, the first color filter 231, the second color filter 233, and the third color filter 235 on one surface of the second base portion 310. In some embodiments, the low refractive index layer 391 may be in direct contact with the first color filter 231, the second color filter 233, and the third color filter 235. In addition, in some embodiments, the low refractive index layer 391 may also be in direct contact with the light blocking pattern 250.

The low refractive index layer 391 may have a refractive index lower than those of wavelength conversion patterns 340 and 350 and a light transmission pattern 330. For example, the low refractive index layer 391 may be made of an inorganic material. For example, the low refractive layer 391 may include silicon nitride, aluminium nitride, zirconium nitride, titanium nitride, hafnium nitride, tantalum nitride, silicon oxide, aluminium oxide, titanium oxide, tin oxide, cerium oxide, silicon oxynitride, or the like. In some embodiments, a plurality of hollow particles may be formed inside the low refractive index layer in order to lower the refractive index of the low refractive index layer 391.

A low refractive index capping layer 392 may be further disposed between the low refractive index layer 391 and the wavelength conversion patterns 340 and 350 and between the low refractive index layer 391 and the light transmission pattern 330. In some embodiments, the low refractive index capping layer 392 may be in direct contact with the wavelength conversion patterns 340 and 350 and the light transmission pattern 330. In addition, in some embodiments, the low refractive index capping layer 392 may also be in direct contact with the bank pattern 370.

The low refractive index capping layer 392 may have a refractive index lower than those of the wavelength conversion patterns 340 and 350 and the light transmission pattern 330. For example, the low refractive index capping layer 392 may be made of an inorganic material. For example, the low refractive capping layer 392 may include silicon nitride, aluminium nitride, zirconium nitride, titanium nitride, hafnium nitride, tantalum nitride, silicon oxide, aluminium oxide, titanium oxide, tin oxide, cerium oxide, silicon oxynitride, or the like. In some embodiments, a plurality of hollow particles may be formed inside the low refractive index layer in order to lower the refractive index of the low refractive index capping layer 392.

The low refractive capping layer 392 can prevent contamination or damage of the first color filter 231, the second color filter 233, the third color filter 235 and the like due to infiltration of impurities such as moisture or air from the outside. In addition, the low refractive index capping layer 392 may prevent the colorants included in the first color filter 231, the second color filter 233, and the third color filter 235 from diffusing into components, e.g., the first wavelength conversion pattern 340, the second wavelength conversion pattern 350, and the like, other than the first color filter 231, the second color filter 233, and the third color filter 235.

In some embodiments, the low refractive index layer 391 and the low refractive index capping layer 392 may surround the side surface of the light blocking pattern 250 in the non-display area NDA. In addition, in some embodiments, the low refractive index layer 391 may be in direct contact with the second base portion 310 in the non-display area NDA.

The bank pattern 370 may be positioned on one surface of the low refractive index capping layer 392 facing the display substrate 10. In some embodiments, the bank pattern 370 may be positioned directly on one surface of the low refractive index capping layer 392 and be in direct contact with the low refractive index capping layer 392.

In some embodiments, the bank pattern 370 may be disposed to overlap the non-emission area NLA or the light blocking area BA. In some embodiments, as shown in FIG. 9, the bank pattern 370 may surround the first light transmitting area TA1, the second light transmitting area TA2, and the third light transmitting area TA3 in plan view. The bank pattern 370 may partition a space in which the first wavelength conversion pattern 340, the second wavelength conversion pattern 350, and the light transmission pattern 330 are disposed.

In some embodiments, the bank pattern 370 may be formed in one pattern that is integrally connected, but is not limited thereto. In another embodiment, a portion of the bank pattern 370 surrounding the first light transmitting area TA1, a portion of the bank pattern 370 surrounding the second light transmitting area TA2, and a portion of the bank pattern 370 surrounding the third light transmitting area TA3 may be formed in individual patterns separated from each other.

When the first wavelength conversion pattern 340, the second wavelength conversion pattern 350, and the light transmission pattern 330 are formed by a method, i.e., an inkjet printing method, of discharging an ink composition using a nozzle or the like, the bank pattern 370 may serve as a guide for stably positioning the discharged ink composition at a desired position. That is, the bank pattern 370 may function as a barrier wall.

In some embodiments, the bank pattern 370 may overlap the bank layer 150.

As shown in FIG. 12, in some embodiments, the bank pattern 370 may be further positioned in the non-display area NDA. The bank pattern 370 may overlap the light blocking pattern 250 in the non-display area NDA.

In some embodiments, the bank pattern 370 may include an organic material having photocurability. In addition, in some embodiments, the bank pattern 370 may include an organic material having photocurability and including a light blocking material. When the bank pattern 370 has a light blocking property, it is possible to prevent intrusion of light between the emission areas adjacent to each other in the display area DA. For example, the bank pattern 370 may prevent the emission light LE emitted from the second light emitting element ED2 from being incident on the first wavelength conversion pattern 340 that overlaps the first emission area LA1. In addition, the bank pattern 370 may block or prevent external light from penetrating into components positioned below the bank pattern 370 in the non-emission area NLA and the non-display area NDA.

As shown in FIGS. 9 and 12, the first wavelength conversion pattern 340, the second wavelength conversion pattern 350, and the light transmission pattern 330 may be positioned below the low refractive index layer 391. In some embodiments, the first wavelength conversion pattern 340, the second wavelength conversion pattern 350, and the light transmission pattern 330 may be positioned in the display area DA.

The light transmission pattern 330 may overlap the third emission area LA3 or the third light emitting element ED3. The light transmission pattern 330 may be located in a space partitioned by the bank pattern 370 in the third light transmitting area TA3.

In some embodiments, the light transmission pattern 330 may be formed in an island-shaped pattern. Although the drawing shows that the light transmission pattern 330 does not overlap the light blocking area BA, this is merely an example. In some other embodiments, the light transmission pattern 330 may partially overlap the light blocking area BA.

The light transmission pattern 330 may transmit incident light. The emission light LE provided from the third light emitting element ED3 may be blue light as described above. The emission light LE, which is blue light, passes through the light transmission pattern 330 and the third color filter 235 and is emitted to the outside of the display device 1. That is, the emission light LE emitted from the third emission area LA3 to the outside of the display device 1 may be blue light.

In some embodiments, the light transmission pattern 330 may include a third base resin 331, and may further include a third scatterer 333 dispersed in the third base resin 331. Hereinafter, while naming a base resin, a scatterer, and/or a wavelength shifter included in the light transmission pattern 330 and the wavelength conversion patterns 340 and 350, the ordinal numbers of "first", "second", and "third" are added to the components to distinguish the components between the light transmission pattern 330 and the wavelength conversion patterns 340 and 350. However, the ordinal numbers of "first", "second", and "third" attached to the components of the light transmission pattern 330 and the wavelength conversion patterns 340 and 350 are not limited thereto, and they may be attached to the components in changed order.

The third base resin 331 may be made of a material having high light transmittance. In some embodiments, the third base resin 331 may be formed of an organic material. For example, the third base resin 331 may include an organic material such as epoxy resin, acrylic resin, cardo resin, or imide resin.

The third scatterer 333 may have a refractive index different from that of the third base resin 331 and form an optical interface with the third base resin 331. For example, the third scatterer 333 may be light scattering particles. The third scatterer 333 is not particularly limited as long as it is a material capable of scattering at least a portion of the transmitted light, but may be, for example, metal oxide particles or organic particles. Examples of the metal oxide may include titanium oxide (TiO₂), zirconium oxide (ZrO₂), aluminium oxide (Al₂O₃), indium oxide (In₂O₃), zinc oxide (ZnO), tin oxide (SnO₂), and the like. Examples of a material of the organic particles may include acrylic resin and urethane resin, and the like. For example, the third scatterer 333 according to one embodiment may include titanium oxide (TiO₂).

The third scatterer 333 may scatter light in a random direction irrespective of the incident direction of incident light without substantially converting the wavelength of light passing through the light transmission pattern 330. In some embodiments, the light transmission pattern 330 may be in direct contact with the bank pattern 370.

The first wavelength conversion pattern 340 may overlap the first emission area LA1, the first light emitting element ED1, or the first light transmitting area TA1.

In some embodiments, the first wavelength conversion pattern 340 may be located in a space partitioned by the bank pattern 370 in the first light transmitting area TA1.

In some embodiments, the first wavelength conversion pattern 340 may be formed in an island pattern shape. Although the drawing shows that the first wavelength conversion pattern 340 does not overlap the light blocking area BA, this is merely an example. In some other embodiments, the first wavelength conversion pattern 340 may partially overlap the light blocking area BA. In some embodiments, the first wavelength conversion pattern 340 may be in direct contact with the bank pattern 370.

The first wavelength conversion pattern 340 may convert or shift the peak wavelength of incident light to another specific peak wavelength through a first wavelength shifter 345 to be described later, and may emit the light. In some embodiments, the first wavelength conversion pattern 340 may convert the emission light LE provided from the first light emitting element ED1 into red light having a peak wavelength in a range of 610 nm to 650 nm, and may emit the red light.

In some embodiments, the first wavelength conversion pattern 340 may include a first base resin 341 and the first wavelength shifter 345 dispersed in the first base resin 341, and may further include a first scatterer 343 dispersed in the first base resin 341.

The first base resin 341 may be made of a material having high light transmittance. In some embodiments, the first base resin 341 may be formed of an organic material. In some embodiments, the first base resin 341 may be made of the same material as the third base resin 331, or may include at least one of the materials exemplified as the constituent materials of the third base resin 331.

Examples of the first wavelength shifter 345 may include a quantum dot, a quantum bar, a phosphor, and the like. For example, a quantum dot may be a particulate material that emits light of a specific color when an electron transitions from a conduction band to a valence band.

The quantum dot may be a semiconductor nanocrystal material. The quantum dot may have a specific band gap according to its composition and size. Thus, the quantum dot may absorb light and then emit light having an intrinsic wavelength. Examples of semiconductor nanocrystal of quantum dots may include group IV nanocrystal, group II-VI compound nanocrystal, group III-V compound nanocrystal, group IV-VI nanocrystal, a combination thereof, or the like.

The group II-VI compound may be selected from the group consisting of binary compounds, ternary compounds, and quaternary compounds, wherein the binary compounds are selected from the group consisting of CdSe, CdTe, ZnS, ZnSe, ZnTe, ZnO, HgS, HgSe, HgTe, MgSe, MgS and mixtures thereof, the ternary compounds are selected from the group consisting of InZnP, AgInS, CuInS, CdSeS, CdSeTe, CdSTe, ZnSeS, ZnSeTe, ZnSTe, HgSeS, HgSeTe, HgSTe, CdZnS, CdZnSe, CdZnTe, CdHgS, CdHgSe, CdHgTe, HgZnS, HgZnSe, HgZnTe, MgZnSe, MgZnS and mixtures thereof, and the quaternary compounds are selected from the group consisting of HgZnTeS, CdZnSeS, CdZnSeTe, CdZnSTe, CdHgSeS, CdHgSeTe, CdHgSTe, HgZnSeS, HgZnSeTe, HgZnSTe and mixtures thereof.

The group III-V compound may be selected from the group consisting of binary compounds, ternary compounds, and quaternary compounds, wherein the binary compounds are selected from the group consisting of GaN, GaP, GaAs, GaSb, AlN, AlP, AlAs, AlSb, InN, InP, InAs, InSb and mixtures thereof, the ternary compounds are selected from the group consisting of GaNP, GaNAs, GaNSb, GaPAs, GaPSb, AlNP, AlNAs, AlNSb, AlPAs, AlPSb, InGaP, InNP, InAlP, InNAs, InNSb, InPAs, InPSb, GaAlNP and mixtures thereof, and the quaternary compounds are selected from the group consisting of GaAlNAs, GaAlNSb, GaAlPAs, GaAlPSb, GaInNP, GaInNAs, GaInNSb, GaInPAs, GaInPSb, InAlNP, InAlNAs, InAlNSb, InAlPAs, InAlPSb and mixtures thereof.

The group IV-VI compound may be selected from the group consisting of binary compounds, ternary compounds, and quaternary compounds, wherein the binary compounds are selected from the group consisting of SnS, SnSe, SnTe, PbS, PbSe, PbTe and mixtures thereof, the ternary compounds are selected from the group consisting of SnSeS, SnSeTe, SnSTe, PbSeS, PbSeTe, PbSTe, SnPbS, SnPbSe, SnPbTe and mixtures thereof, and the quaternary compounds are selected from the group consisting of SnPbSSe, SnPbSeTe, SnPbSTe and mixtures thereof. The group IV element may be selected from the group consisting of Si, Ge and mixtures thereof. The group IV compound may be a binary compound selected from the group consisting of SiC, SiGe and mixtures thereof.

In this case, the binary compound, the tertiary compound or the quaternary compound may exist in particles at a uniform concentration, or may exist in the same particle divided into states where concentration distributions are partially different. Further, the particles may have a core/shell structure in which one quantum dot surrounds another quantum dot. An interface between the core and the shell may have a concentration gradient in which the concentration of elements present in the shell decreases toward the center.

In some embodiments, the quantum dot may have a core-shell structure including a core including the nanocrystal described above and a shell surrounding the core. The shell of the quantum dot may serve as a protective layer for maintaining semiconductor characteristics by preventing chemical denaturation of the core and/or as a charging layer for giving electrophoretic characteristics to the quantum dot. The shell may be a single layer or a multilayer. An interface between the core and the shell may have a concentration gradient in which the concentration of elements present in the shell decreases toward the center. Examples of the shell of the quantum dot may include a metal or non-metal oxide, a semiconductor compound, and a combination thereof.

For example, the metal or non-metal oxide may be a binary compound such as SiO₂, Al₂O₃, TiO₂, ZnO, MnO, Mn₂O₃, Mn₃O₄, CuO, FeO, Fe₂O₃, Fe₃O₄, CoO, Co₃O₄ and NiO, or a tertiary compound such as MgAl₂O₄, CoFe₂O₄, NiFe₂O₄ and CoMn₂O₄, but the present invention is not limited thereto.

In addition, the semiconductor compound may be, for example, CdS, CdSe, CdTe, ZnS, ZnSe, ZnTe, ZnSeS, ZnTeS, GaAs, GaP, GaSb, HgS, HgSe, HgTe, InAs, InP, InGaP, InSb, AlAs, AlP, AlSb or the like, but the present invention is not limited thereto.

The light emitted from the first wavelength shifter 345 may have a full width of half maximum (FWHM) of the emission wavelength spectrum, which is about 45 nm or less, about 40 nm or less, or about 30 nm or less. Thus, the purity and reproducibility of colors displayed by the display device 1 can be further improved. In addition, the light emitted from the first wavelength shifter 345 may be emitted in various directions regardless of the incident direction of incident light. Through this, the side visibility of the first color displayed in the first light transmitting area TA1 may be improved.

Part of the emission light LE provided from the first light emitting element ED1 may pass through the first wavelength conversion pattern 340 to be emitted without being converted into red light by the first wavelength shifter 345. A component of the emission light LE incident on the first color filter 231 without being converted by the first wavelength conversion pattern 340 may be blocked by the first color filter 231. On the other hand, the emission light LE that has converted into red light by the first wavelength conversion pattern 340 passes through the first color filter 231 to be emitted to the outside. That is, the emission light LE emitted to the outside of the display device 1 through the first light transmitting area TA1 may be red light.

The first scatterer 343 may have a refractive index different from that of the first base resin 341 and form an optical interface with the first base resin 341. For example, the first scatterer 343 may be light scattering particles. A more detailed description of the first scatterer 343 is substantially the same as or similar to the description of the third scatterer 333, and thus will be omitted.

The second wavelength conversion pattern 350 may be located in a space partitioned by the bank pattern 370 in the second light transmitting area TA2.

In some embodiments, the second wavelength conversion pattern 350 may be formed in an island pattern shape as shown in FIG. 9. In some embodiments, unlike that shown in the drawings, a part of the second wavelength conversion pattern 350 may overlap the light blocking area BA. In some embodiments, the second wavelength conversion pattern 350 may be in direct contact with the bank pattern 370.

The second wavelength conversion pattern 350 may convert or shift the peak wavelength of incident light to another specific peak wavelength through a second wavelength shifter 355 to be described later, and may emit the light. In some embodiments, the second wavelength conversion pattern 350 may convert the emission light LE provided from the second light emitting element ED2 into green light having a peak wavelength in a range of about 510 nm to about 550 nm, and may emit the green light.

In some embodiments, the second wavelength conversion pattern 350 may include a second base resin 351 and the second wavelength shifter 355 dispersed in the second base resin 351, and may further include a second scatterer 353 dispersed in the second base resin 351.

The second base resin 351 may be made of a material having high light transmittance. In some embodiments, the second base resin 351 may be formed of an organic material. In some embodiments, the second base resin 351 may be made of the same material as the third base resin 331, or may include at least one of the materials exemplified as the constituent materials of the third base resin 331.

Examples of the second wavelength shifter 355 may include a quantum dot, a quantum rod, a phosphor, and the like. A more detailed description of the second wavelength shifter 355 is substantially the same as or similar to the description of the first wavelength shifter 345, and thus will be omitted.

In some embodiments, both the first wavelength shifter 345 and the second wavelength shifter 355 may be formed of quantum dots. In this case, the particle size of the quantum dots constituting the second wavelength shifter 355 may be smaller than the particle size of the quantum dots constituting the first wavelength shifter 345.

The second scatterer 353 may have a refractive index different from that of the second base resin 351 and form an optical interface with the second base resin 351. For example, the second scatterer 353 may be light scattering particles. A more detailed description of the second scatterer 353 is substantially the same as or similar to the description of the first scatterer 343, and thus will be omitted.

The emission light LE emitted from the third light emitting element ED3 may be provided to the second wavelength conversion pattern 350, and the second wavelength shifter 355 may convert the emission light LE provided from the third light emitting element ED3 into green light having a peak wavelength in a range of about 510 nm to about 550 nm, and may emit the green light.

Part of the emission light LE, which is blue light, may pass through the second wavelength conversion pattern 350 without being converted into green light by the second wavelength shifter 355, and then may be blocked by the second color filter 233. On the other hand, the emission light LE that has converted into green light by the second wavelength conversion pattern 350 passes through the second color filter 233 to be emitted to the outside. Accordingly, the emission light LE emitted from the second light transmitting area TA2 to the outside of the display device 1 may be green light.

In some embodiments, a capping layer 393 may cover the outer side surface of the bank pattern 370 in the non-display area NDA. In addition, the capping layer 393 may be in direct contact with the low refractive index capping layer 392 in the non-display area NDA.

In some embodiments, the capping layer 393 may be formed of an inorganic material. In some embodiments, the capping layer 393 may be made of the same material as the low refractive index layer 391, or may include at least one of the materials mentioned in the description of the low refractive index layer 391. When both the low refractive index layer 391 and the capping layer 393 are made of an inorganic material, the low refractive index layer 391 and the capping layer 393 may be in direct contact with each other to form an inorganic-inorganic junction in the non-display area NDA.

As described above, the sealing member 50 may be positioned between the color conversion substrate 30 and the display substrate 10 in the non-display area NDA.

The sealing member 50 may overlap the encapsulation layer 170. More specifically, the sealing member 50 may overlap the lower inorganic layer 171 and the upper inorganic layer 175, and may not overlap the organic layer 173. In some embodiments, the sealing member 50 may be in direct contact with the encapsulation layer 170. More specifically, the sealing member 50 may be positioned directly on the upper inorganic layer 175 and be in direct contact with the upper inorganic layer 175.

In some embodiments, the upper inorganic layer 175 and the lower inorganic layer 171 positioned below the sealing member 50 may extend to the outside of the sealing member 50.

The sealing member 50 may overlap the color pattern 250, the first color filter 231, and the bank pattern 370 in the non-display area NDA. In some embodiments, the sealing member 50 may be in direct contact with the capping layer 393 that covers the bank pattern 370.

As described above, the sealing member 50 may be in direct contact with the exposed top surface 117u of the passivation layer 117. The sealing member 50 may be disposed to overlap the second signal line WR2 disposed in the first conductive layer and not to overlap the first and third signal lines WR1 and WR3 disposed in the second conductive layer. The sealing member 50 may include an organic insulating material, and for example, the sealing member 50 may include a sealant. The passivation layer 117 in contact with the sealing member 50 may include an inorganic material. Since the sealing member 50 is in direct contact with the passivation layer 117 containing an inorganic material, close adhesion (or close bonding) between the bottom surface of the sealing member 50 and the top surface 117u of the passivation layer 117 may be possible without intervening an empty space therebetween. Accordingly, as shown in FIG. 12, it is possible to significantly reduce the possibility that external air or moisture entering from the outside of the sealing area SA passes between the sealing member 50 and the passivation layer 117 to penetrate into the display area DA.

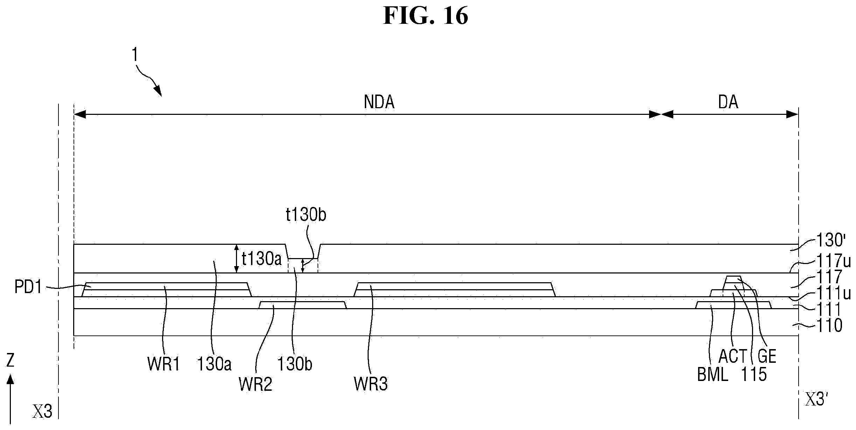

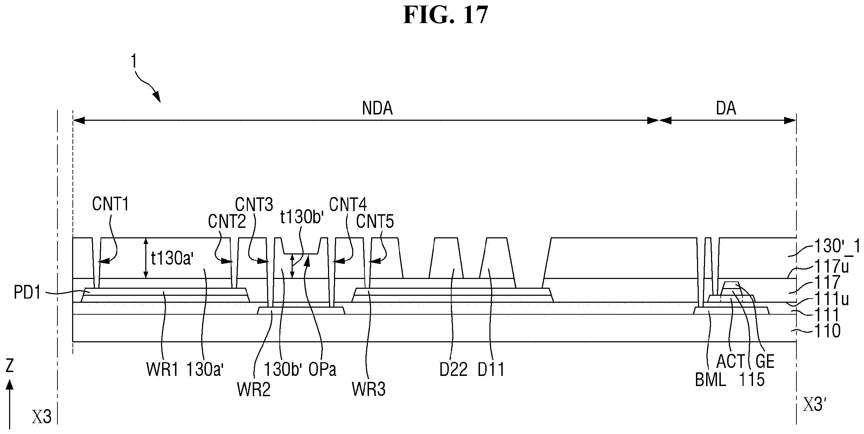

In order to form a structure in which the sealing member 50 and the passivation layer 117 are in direct contact with each other in the sealing area SA, as in the manufacturing method of the display device 1 of FIGS. 16 to 18 to be described later, a thickness t130b of a via layer 130b in the sealing area SA is formed smaller than a thickness t130a of a via layer 130a in the remaining area (see FIG. 16), and after forming the contact holes CNT1 to CNT5 (see FIG. 17) in a via layer 130' of FIG. 16, the thickness of a via layer 130'_1 is reduced over the entire surface. The process of reducing the thickness of the via layer 130'_1 is performed through an ashing process. Through the ashing process, the via layer in the sealing area SA is removed (the first open portion OPa of the via layer 130 is formed), and a thickness t130 of the via layer 130 in the remaining area may be more reduced than the thickness t130a' the via layer 130a' before the ashing process. Meanwhile, in the process of removing the via layer in the sealing area SA through the ashing process, a part and/or the whole of the passivation layer 117 under the via layer 130b' (see FIG. 17) may also be removed. Unlike one embodiment, if the second signal line WR2 is positioned in the second conductive layer, or the second signal line WR2 is omitted and a signal line connected to the pad electrode PD is formed of only the second conductive layer, in the process of removing the via layer in the sealing area SA through the ashing process, when a part and/or the whole of the passivation layer 117 under the via layer 130b' (FIG. 17) is removed, the signal line formed of the second conductive layer may be exposed in the sealing area SA. In this case, it is difficult to expect the function of preventing moisture permeation and/or intrusion of external air through the above-described sealing member 50, and corrosion of the signal line exposed in the sealing area SA may also occur.

However, in the case of the display device 1 according to one embodiment, as described above, in the outside of the sealing area SA in plan view, the second signal line WR2 disposed in the first conductive layer may be connected to the first signal line WR1 of the second conductive layer connected to the pad electrode PD, and in the inside of the sealing area SA in plan view, the second signal line WR2 may be connected to the third signal line WR3 of the second conductive layer. For this reason, in the process of removing the via layer in the sealing area SA through the ashing process, even if a part and/or the whole of the passivation layer 117 below the via layer 130b' (see FIG. 17) is removed, the possibility that the second signal line WR2 disposed below the buffer layer 111 is exposed to the outside is greatly reduced. Accordingly, there is an advantage that the function of preventing moisture permeation and/or intrusion of external air through the above-described sealing member 50 can be easily performed, and corrosion of the signal lines WR1, WR2, and WR3 can also be prevented in advance.

As described above, the filler 70 may be positioned in spaces between the color conversion substrate 30, the display substrate 10, and the sealing member 50. In some embodiments, as shown in FIGS. 9 and 12, the filler 70 may be in direct contact with the capping layer 393 and the upper inorganic layer 175 of the encapsulation layer 170.

An anti-reflection film AF may be further disposed on a surface of the second base portion 310 opposite to a surface thereof in contact with the color filters 231, 233, and 235 in the display device 1 according to one embodiment. The anti-reflection film AF may be disposed on a surface of the second base portion 310 opposite to a surface thereof in contact with the color filters 231, 233, and 235 to minimize external light from being incident into the display device 1. The anti-reflection film AF may include a first surface positioned close to a display surface and a second surface (surface in contact with the second base portion 310) opposite to the first surface, and may minimize incidence of external light into the display device 1 by a principle of mutually interfering the external light reflected from the first surface and the external light reflected from the second surface. Although not shown, the antireflection film AF may be formed of a plurality of layers having a controlled refractive index, but is not limited thereto.

Hereinafter, a method of manufacturing the display device 1 will be described.

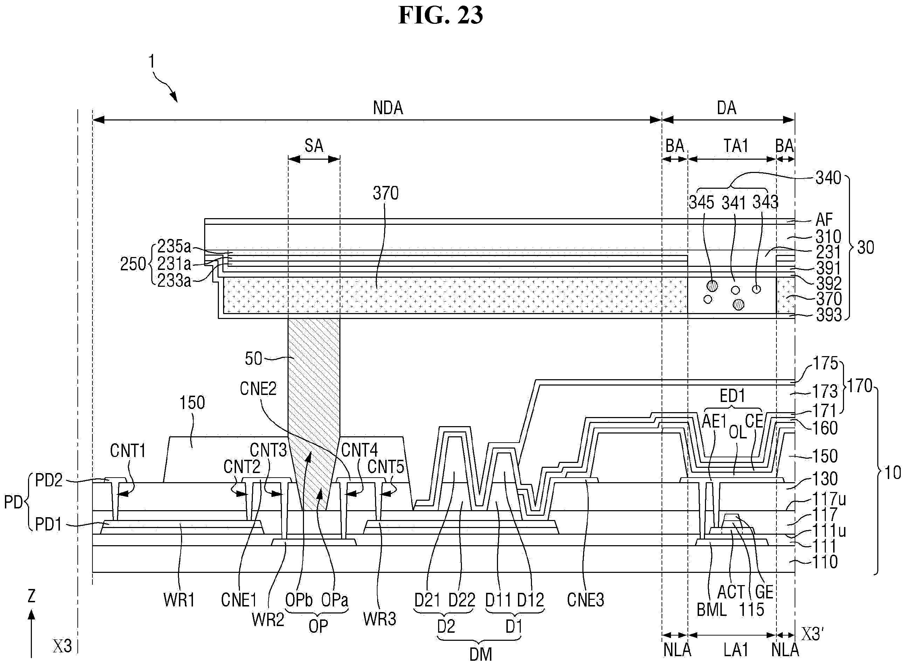

FIGS. 16 to 23 are cross-sectional views illustrating process steps of a manufacturing method of a display device according to one embodiment. While describing the manufacturing method of the display device 1 with reference to FIGS. 16 to 23, FIGS. 9 and 12 may be further referred to.

A manufacturing method of the display device 1 according to one embodiment may include: a step of preparing the display substrate 10 in which the display area DA and the non-display area NDA positioned around the display area DA are defined; a step of bonding the color conversion substrate 30 to the display substrate 10 through the sealing member 50 disposed in the sealing area SA of the non-display area NDA; and a step of filling the filler 70 between the sealing member 50, the display substrate 10, and the color conversion substrate 30.

As shown in FIGS. 12 and 16, the step of preparing the display substrate 10 may include: a step of forming the first conductive layer including the second signal line WR2 and the lower light blocking layer BML on the first base portion 110; a step of forming the buffer layer 111 on the first conductive layer; a step of forming the semiconductor layer ACT overlapping the lower light blocking layer BML on the buffer layer 111; a step of forming the gate insulating layer 115 on the semiconductor layer ACT; a step of forming on the gate insulating layer 115 the second conductive layer including the first signal line WR1 and the third signal line WR3 electrically connected to the second signal line WR2, the first pad electrode PD1 connected to the outer end of the first signal line WR1, and the gate electrode GE overlapping the semiconductor layer ACT; a step of forming the passivation layer 117 on the second conductive layer; and a step of forming the via layer 130' on the passivation layer 117.

In plan view, the second signal line WR2 may be disposed between the first signal line WR1 and the third signal line WR3, and the second signal line WR2 may be disposed in the sealing area SA to overlap the sealing member 50 (see FIG. 12).

Meanwhile, as shown in FIG. 16, in the step of forming the via layer 130', the thickness t130b of the via layer 130b in the sealing area SA may be smaller than the thickness t130a of the via layer 130a in an area excluding the sealing area SA.

Next, as shown in FIGS. 12 and 17, the step of forming the display substrate 10 may further include, after the step of forming the via layer 130', a step of forming the contact holes CNT1, CNT2, CNT3, CNT4, and CNT5 in the via layer 130' of FIG. 16.

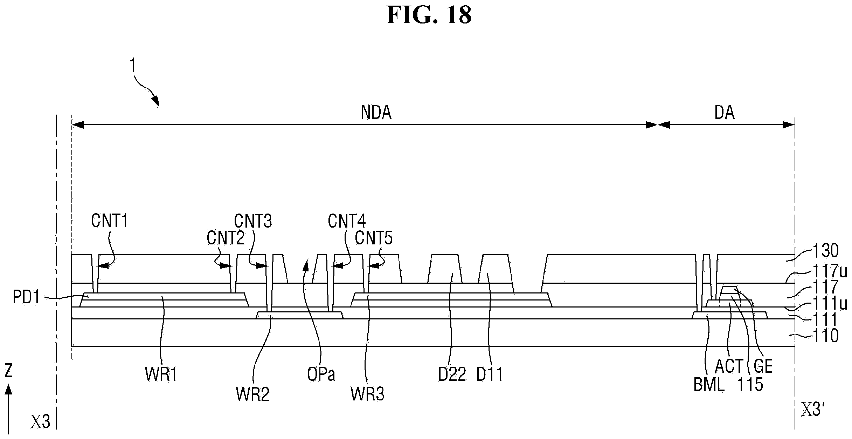

Subsequently, as shown in FIGS. 12 and 18, in the step of forming the display substrate 10, after the step of forming the contact holes CNT1, CNT2, CNT3, CNT4, and CNT5 in the via layer 130', a process of reducing the thickness of the via layer 130'_1 is performed. This process is performed through an ashing process. Through the ashing process, the via layer in the sealing area SA may be removed (the first open portion OPa of the via layer 130 is formed), and the thickness t130 of the via layer 130 in the remaining area may become smaller than the thickness t130a' of the via layer 130a' before the ashing process.

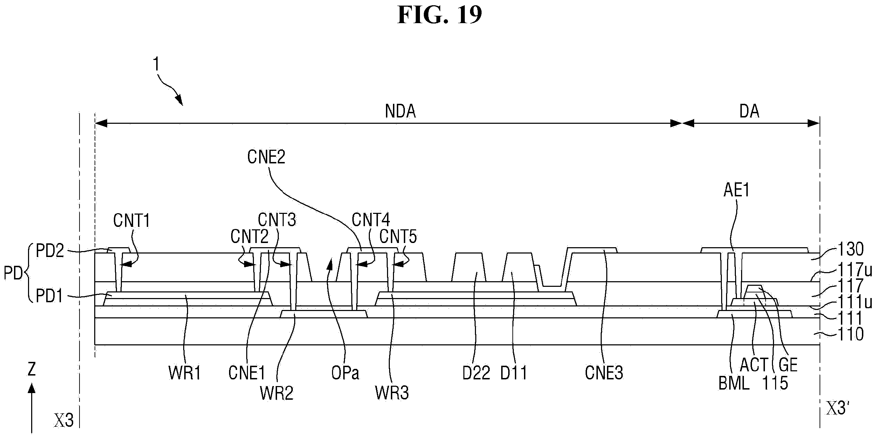

Next, as shown in FIGS. 12 and 19 in the step of forming the display substrate 10, after the process of reducing the thickness of the via layer 130'_1, a step of forming the third conductive layer may be further performed. The third conductive layer may include the second pad electrode PD2, the connection electrodes CNE1, CNE2, and CNE3, and the anode electrodes AE1, AE2, and AE3.

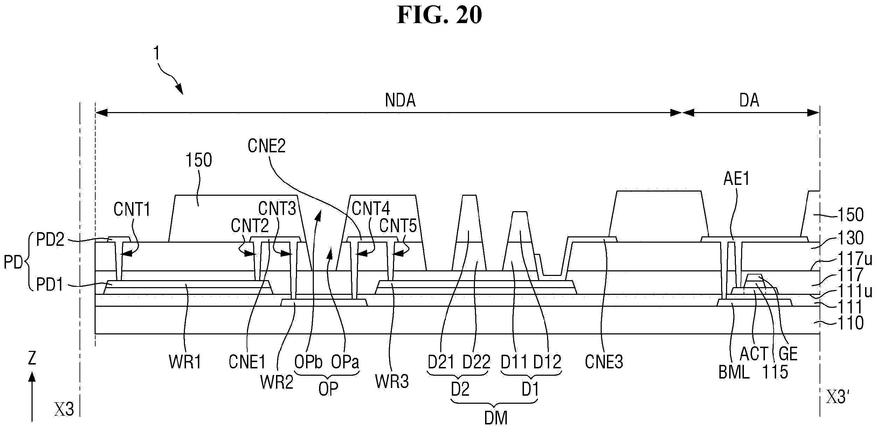

Subsequently, as shown in FIGS. 12 and 20, the step of forming the display substrate 10 may further include a step of forming the bank layer 150 after the step of forming the third conductive layer. The bank layer 150 may include a second open portion OPb described above. The arrangement and material of the bank layer 150 has been described above in detail with reference to FIGS. 8 and 12, and thus a detailed description thereof will be omitted.

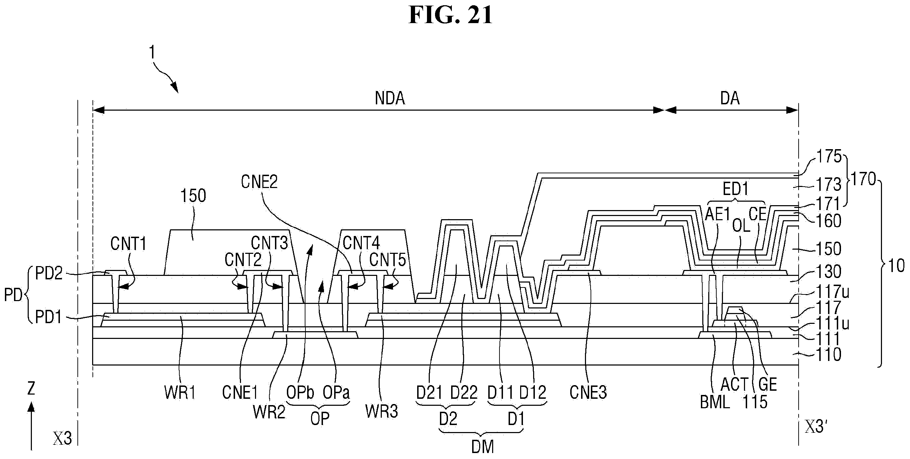

Next, as shown in FIGS. 12 and 21, the step of forming the display substrate 10 may further include, after the step of forming the bank layer 150, a step of forming the light emitting layer OL, the cathode electrode CE, the first capping layer 160, and the encapsulation layer 170 on the bank layer 150.

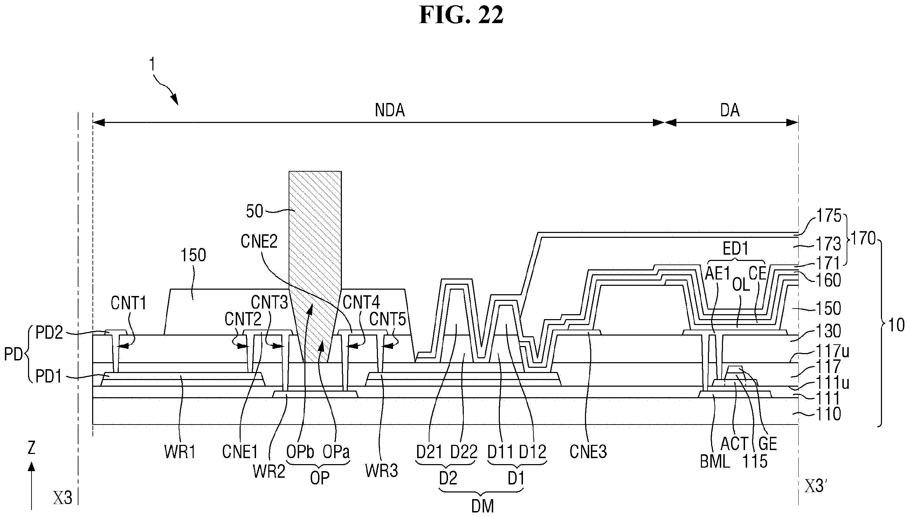

Thereafter, as shown in FIGS. 12 and 22, the step of forming the display substrate 10 may further include, after the step of forming the encapsulation layer 170, a step of providing the sealing member 50 in the sealing area SA. As described above, the sealing member 50 may be brought into direct contact with the exposed top surface 117u of the passivation layer 117. The sealing member 50 may be disposed to overlap the second signal line WR2 disposed in the first conductive layer and not to overlap the first and third signal lines WR1 and WR3 disposed in the second conductive layer. The sealing member 50 may include an organic insulating material, and for example, the sealing member 50 may include a sealant. The passivation layer 117 in contact with the sealing member 50 may include an inorganic material. Since the sealing member 50 is in direct contact with the passivation layer 117 containing an inorganic material, close adhesion (or close bonding) between the bottom surface of the sealing member 50 and the top surface 117u of the passivation layer 117 may be possible without intervening an empty space therebetween.

In the manufacturing method of the display device 1 according to one embodiment, as described above, in the outside of the sealing area SA in plan view, the second signal line WR2 disposed in the first conductive layer may be connected to the first signal line WR1 of the second conductive layer connected to the pad electrode PD and in the inside of the sealing area SA in plan view, the second signal line WR2 may be connected to the third signal line WR3 of the second conductive layer. For this reason, in the process of removing the via layer in the sealing area SA through the ashing process, even if a part and/or the whole of the passivation layer 117 below the via layer 130b' (see FIG. 17) is removed, the possibility that the second signal line WR2 disposed below the buffer layer 111 is exposed to the outside is greatly reduced. Accordingly, there is an advantage that the function of preventing moisture permeation and/or intrusion of external air through the above-described sealing member 50 can be easily performed, and corrosion of the signal lines WR1, WR2, and WR3 can also be prevented in advance.

Hereinafter, other embodiments of the display device 1 will be described.

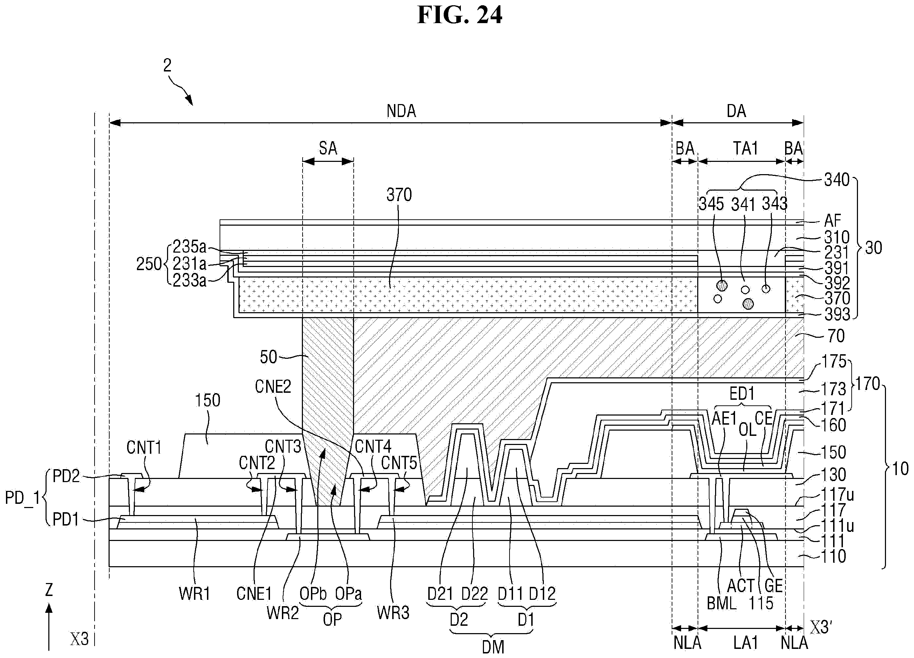

FIG. 24 is a cross-sectional view of a display device according to another embodiment.

Referring to FIG. 24, a display device 2 according to the present embodiment differs from the display device 1 of FIG. 12 in that a pad electrode PD_1 may be the first power pad electrode or the driving pad electrode. For this reason, unlike the third signal line WR3 of FIG. 12, the third signal line WR3 connected to the pad electrode PD_1 may be electrically connected to the first voltage line VL1 of FIG. 3 without being connected to the cathode electrode CE.

Since other descriptions have been made with reference to FIG. 12, detailed descriptions are omitted.

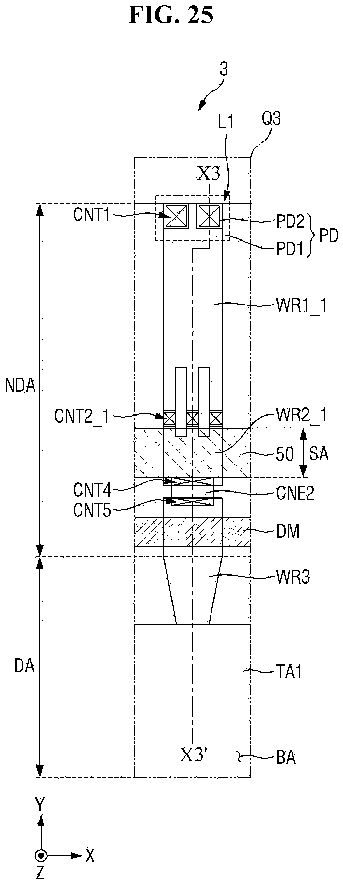

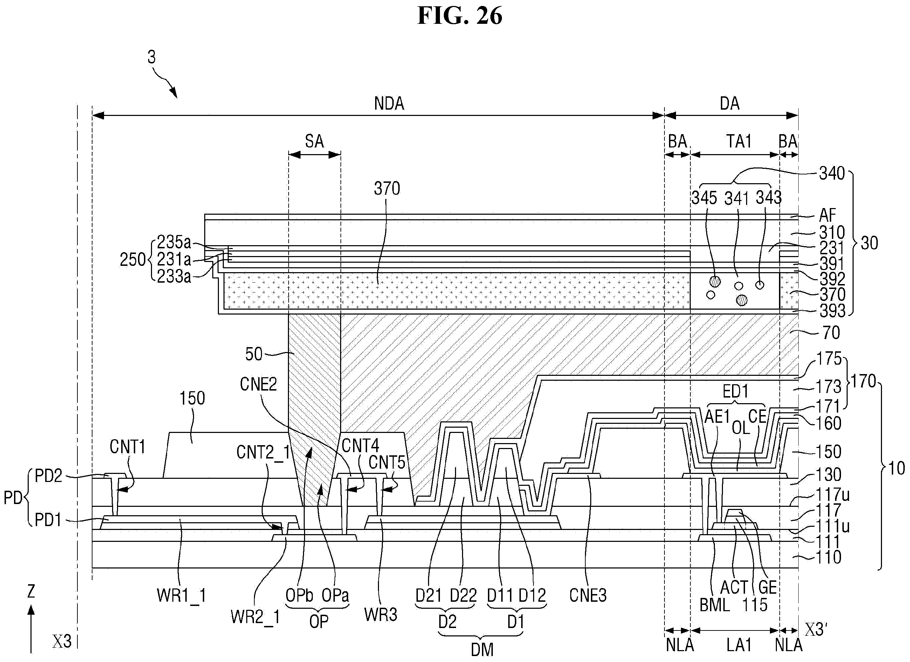

FIG. 25 is a plan view illustrating a non-display area and a display area of a display device according to still another embodiment. FIG. 26 is a cross-sectional view of a display device according to one embodiment taken along line X3-X3' of FIG. 25.

Referring to FIGS. 25 and 26, a display device 3 according to the present embodiment differs from the display device 1 of FIGS. 8 and 12 in that a first signal line WR1_1 and a second signal line WR2_1 may be directly connected to each other through a second contact hole CNT2_1.

In the display device 3 according to the present embodiment, the first connection electrode CNE1 of FIG. 12 may be omitted.

Since other descriptions have been made with reference to FIG. 12, detailed descriptions are omitted.

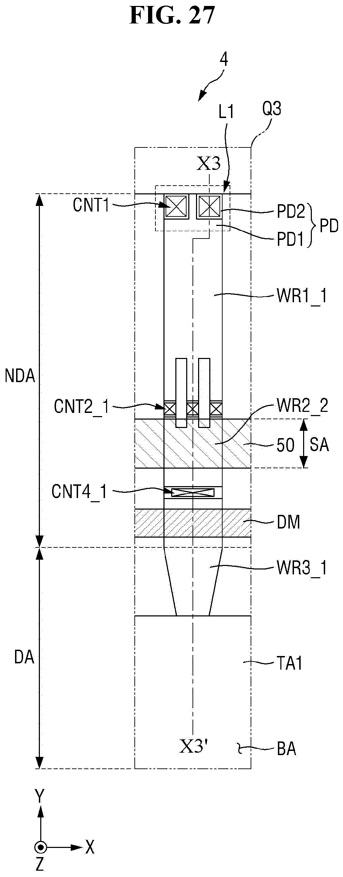

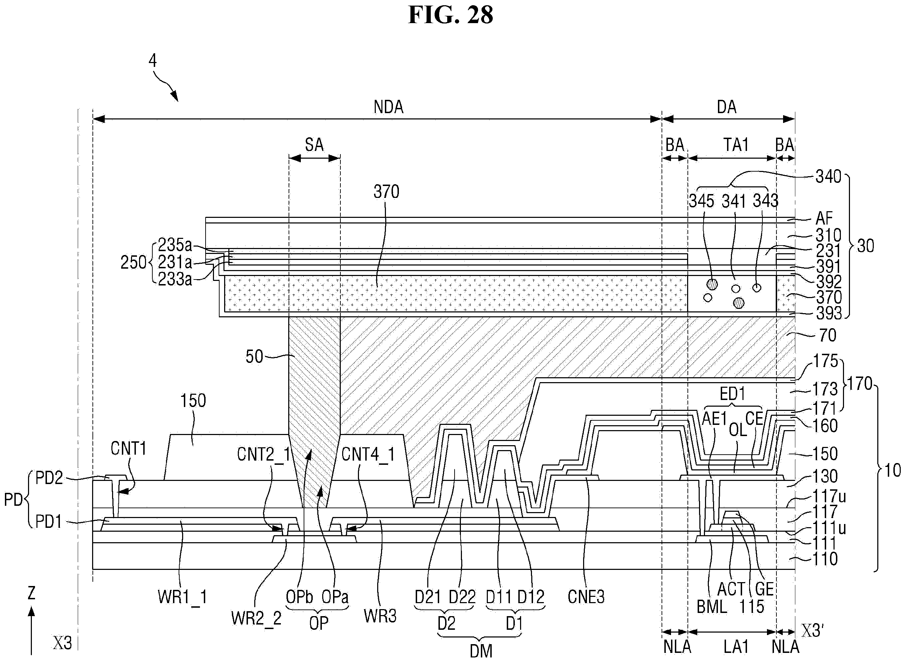

FIG. 27 is a plan view illustrating a non-display area and a display area of a display device according to still another embodiment. FIG. 28 is a cross-sectional view of a display device according to one embodiment taken along line X3-X3' of FIG. 27.

Referring to FIGS. 27 and 28, a display device 4 according to the present embodiment differs from the display device 3 of FIGS. 25 and 26 in that a second signal line WR2_2 and a third signal line WR3_1 may be directly connected to each other through a fourth contact hole CNT4_1.

In the display device 4 according to the present embodiment, the second connection electrode CNE2 of FIGS. 25 and 26 may be omitted.

Since other descriptions have been made with reference to FIGS. 12, 25 and 26, detailed descriptions will be omitted below.

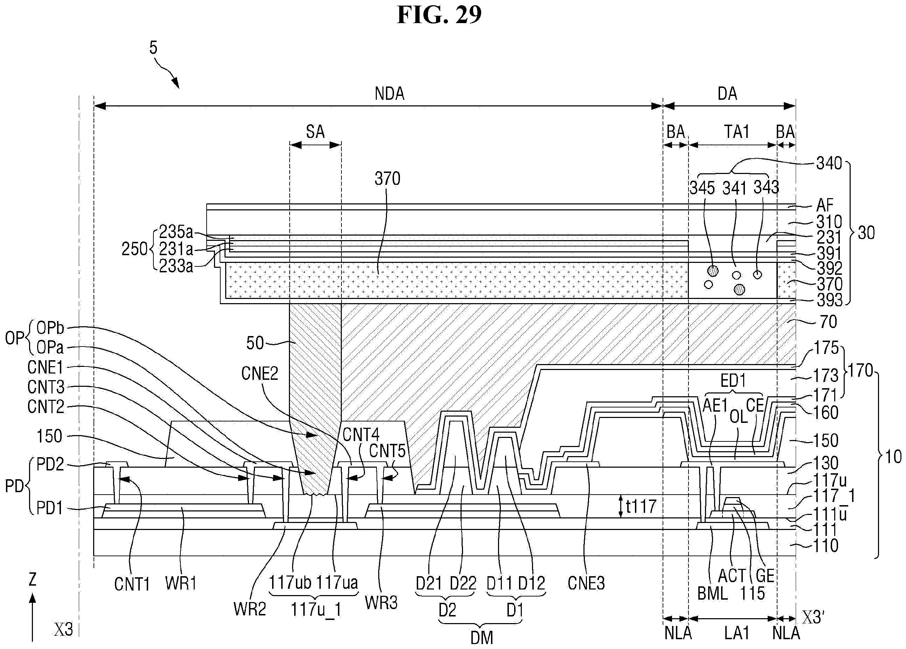

FIG. 29 is a cross-sectional view of a display device according to still another embodiment.

Referring to FIG. 29, a display device 5 according to the present embodiment differs from the display device 1 of FIG. 12 in that a top surface 117u_1 of a passivation layer 117_1 may include a first top surface 117ua in an area excluding the sealing area SA, and a second top surface 117ub in the sealing area SA.

The roughness of the second top surface 117ub may be greater than that of the first top surface 117ua. The roughness of the second top surface 117ub is greater than that of the first top surface 117ua because in the process of forming the via layer 130 through the ashing process of FIG. 18, an ashing gas or the like used in the ashing process is brought into physical contact with the second top surface 117ub of the passivation layer 117_1 exposed in the sealing area SA.

Since other descriptions have been made with reference to FIG. 12, detailed descriptions are omitted.

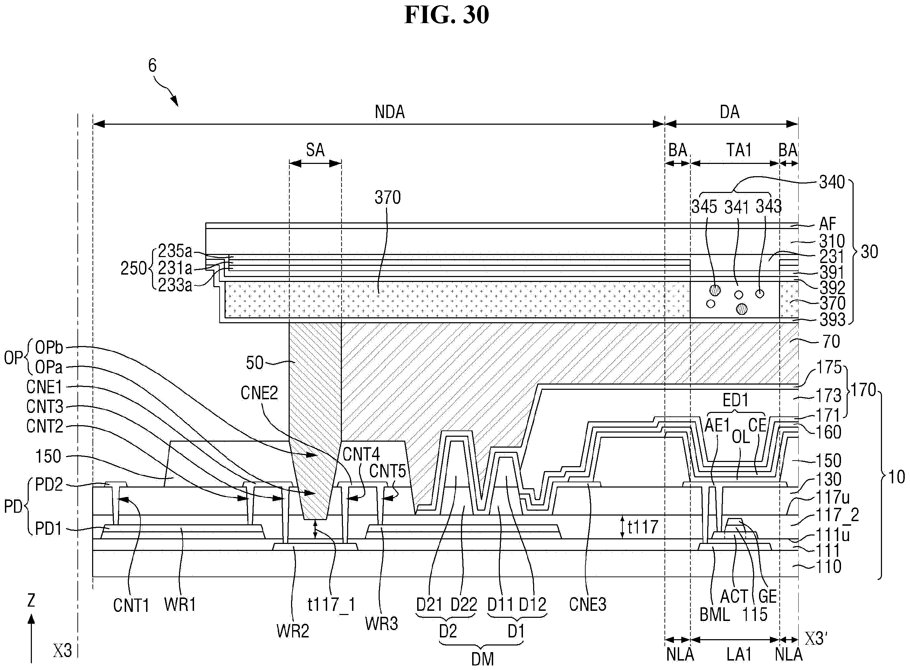

FIG. 30 is a cross-sectional view of a display device according to still another embodiment.

Referring to FIG. 30, a display device 6 according to the present embodiment differs from the display device 1 of FIG. 12 in that a thickness t117_1 of a passivation layer 117_2 in the sealing area SA is smaller than a thickness t117 thereof in the remaining area.

The thickness t117_1 of the passivation layer 117_2 in the sealing area SA is smaller than the thickness t117 thereof in the remaining area because in the process of forming the via layer 130 through the ashing process of FIG. 18, an ashing gas or the like used in the ashing process is brought into physical contact with the passivation layer 117_2 exposed in the sealing area SA to reduce the thickness t117_1 of the passivation layer 117_2 in the sealing area SA.

Since other descriptions have been made with reference to FIG. 12, detailed descriptions are omitted.

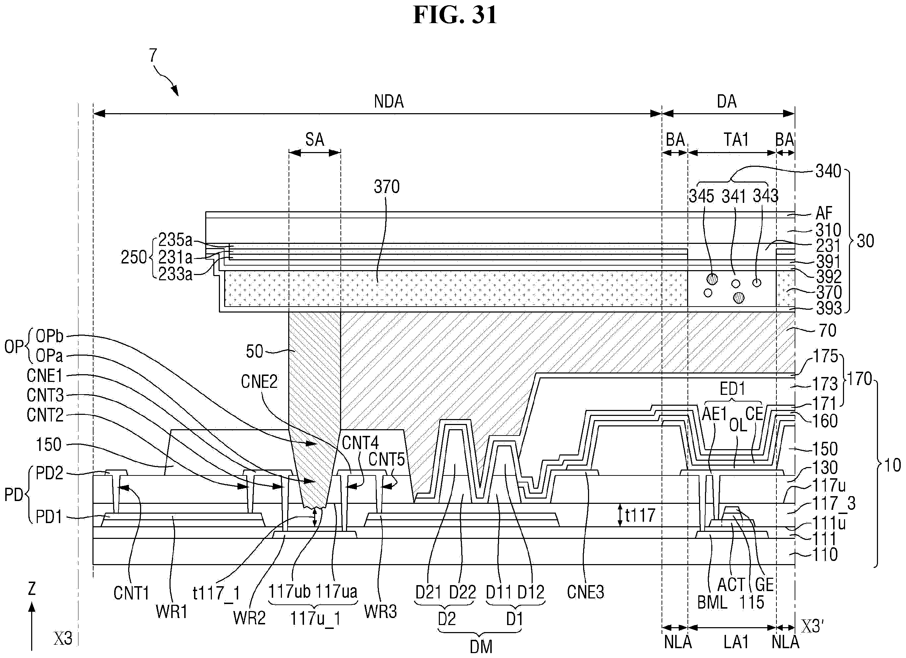

FIG. 31 is a cross-sectional view of a display device according to still another embodiment.

Referring to FIG. 31, a display device 7 according to the present embodiment differs from the display device 6 of FIG. 30 in that a top surface 117u_1 of a passivation layer 117_3 may include a first top surface 117ua in an area excluding the sealing area SA, and a second top surface 117ub in the sealing area SA.

The roughness of the second top surface 117ub may be greater than that of the first top surface 117ua. The roughness of the second top surface 117ub is greater than that of the first top surface 117ua because in the process of forming the via layer 130 through the ashing process of FIG. 18, an ashing gas or the like used in the ashing process is brought into physical contact with the second top surface 117ub of the passivation layer 117_1 exposed in the sealing area SA.

Since other descriptions have been made with reference to FIG. 30, detailed descriptions are omitted.

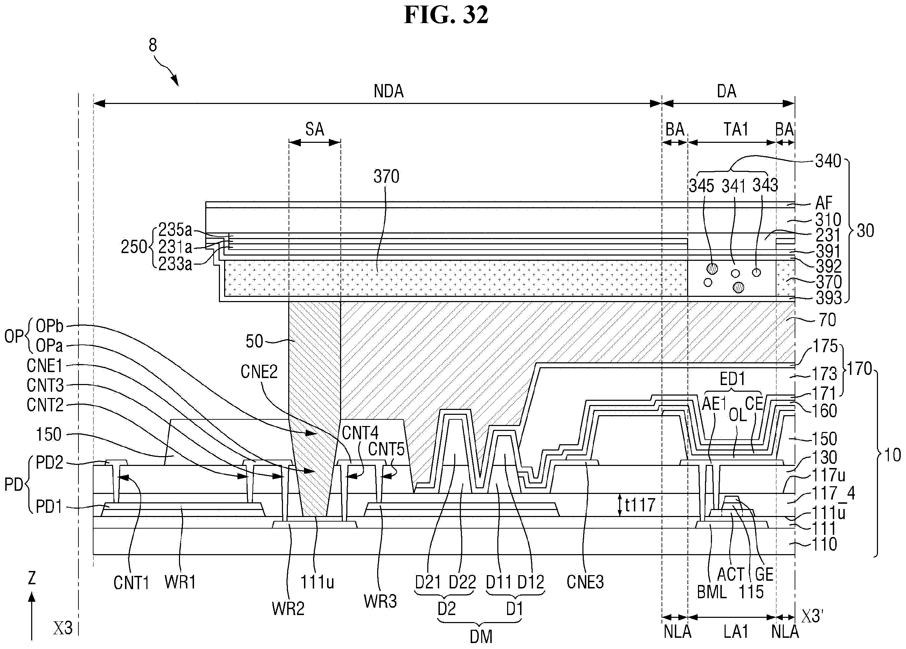

FIG. 32 is a cross-sectional view of a display device according to still another embodiment.

Referring to FIG. 32, a display device 8 according to the present embodiment differs from the display device 6 of FIG. 30 in that a passivation layer 117_4 is not disposed in the sealing area SA.

The passivation layer 117_4 is not disposed in the sealing area SA because in the process of forming the via layer 130 through the ashing process of FIG. 18, an ashing gas or the like used in the ashing process is brought into physical contact with the passivation layer 117_4 exposed in the sealing area SA to gradually reduce the thickness of the passivation layer 117_4 and eventually remove the passivation layer 117_4 in the sealing area SA. Since the passivation layer 117_4 is not disposed in the sealing area SA, a top surface 111u of the buffer layer 111 may be exposed in the sealing area SA, and the exposed top surface 111u may be in direct contact with the sealing member 50.

Since other descriptions have been made with reference to FIG. 30, detailed descriptions are omitted.

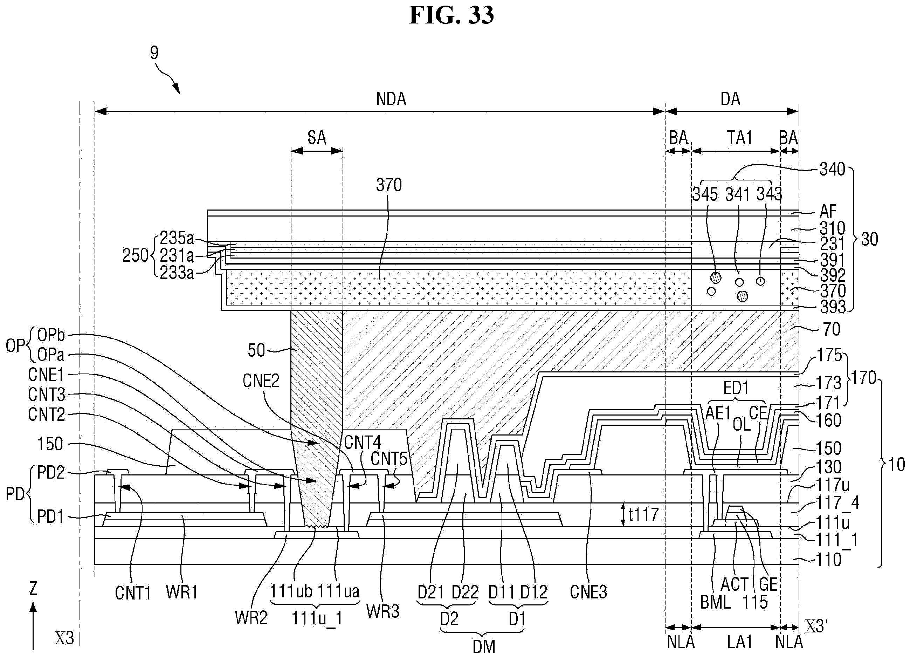

FIG. 33 is a cross-sectional view of a display device according to still another embodiment.

Referring to FIG. 33, a display device 9 according to the present embodiment differs from the display device 8 of FIG. 32 in that a top surface 111u_1 of a buffer layer 111_1 may include a first top surface 111ua in an area excluding the sealing area SA, and a second top surface 111ub in the sealing area SA.

The roughness of the second top surface 111ub may be greater than that of the first top surface 111ua. The roughness of the second top surface 111ub is greater than that of the first top surface 111ua because in the process of forming the via layer 130 through the ashing process of FIG. 18, an ashing gas or the like used in the ashing process is brought into physical contact with the top surface 111ub of the buffer layer 111_1 exposed in the sealing area SA.

Since other descriptions have been made with reference to FIG. 32, detailed descriptions are omitted.

Although the embodiments of the present invention have been described with reference to the attached drawings, those skilled in the art will understand that the present invention can be implemented in other specific forms without changing the technical idea or essential features of the present invention. Therefore, it should be understood that the embodiments described above are exemplary in all respects and not restrictive.

## Claims

1. A display device comprising:
a first substrate in which a display area and a non-display area positioned around the display area are defined;
a second substrate disposed on the first substrate; and
a sealing member disposed in a sealing area of the non-display area to bond the first substrate to the second substrate,
wherein the first substrate comprises:
a first base portion;
a first conductive layer comprising a first signal line and a lower light blocking layer, on the first base portion;
a buffer layer on the first conductive layer;
a semiconductor layer overlapping the lower light blocking layer, on the buffer layer;
a gate insulating layer on the semiconductor layer; and
a second conductive layer comprising a second signal line and a third signal line electrically connected to the first signal line, and a gate electrode overlapping the semiconductor layer, on the gate insulating layer,
wherein in plan view, the first signal line is disposed between the second signal line and the third signal line, and
the first signal line is disposed to overlap the sealing member.

2. The display device of claim 1, wherein the second conductive layer further comprises a first pad connected to an outer end of the second signal line.

3. The display device of claim 2, wherein the first substrate further comprises a passivation layer on the second conductive layer.

4. The display device of claim 3, wherein the first substrate further comprises a via layer on the passivation layer.

5. The display device of claim 4, wherein the via layer contains an organic insulating material.

6. The display device of claim 5, wherein the via layer does not overlap the sealing member.

7. The display device of claim 6, wherein the sealing member is in direct contact with the passivation layer.

8. The display device of claim 4, wherein the first substrate further comprises a third conductive layer comprising a second pad on the via layer, a first connection electrode, a second connection electrode, and a first electrode connected to each of the lower light blocking layer and the semiconductor layer and disposed in the display area.

9. The display device of claim 8, wherein the second pad overlaps the first pad and is connected to the first pad through a first contact hole penetrating the via layer and the passivation layer.

10. The display device of claim 8, wherein the first connection electrode overlaps the second signal line and the first signal line.

11. The display device of claim 10, wherein the first connection electrode is connected to the second signal line through a second contact hole penetrating the via layer and the passivation layer, and is connected to the first signal line through a third contact hole penetrating the via layer, the passivation layer, and the buffer layer.

12. The display device of claim 11, wherein the second connection electrode is connected to the first signal line through a fourth contact hole penetrating the via layer, the passivation layer, and the buffer layer, and is connected to the first signal line through a fifth contact hole penetrating the via layer and the passivation layer.

13. The display device of claim 12, wherein the first substrate further comprises a bank partially exposing a top surface of the first electrode in the display area, an organic layer disposed on the top surface of the first electrode exposed by the bank, and a second electrode on the organic layer, and
the first electrode, the organic layer, and the second electrode constitute a light emitting element.

14. The display device of claim 13, wherein the third signal line is electrically connected to the light emitting element.

15. The display device of claim 13, wherein the bank is disposed up to the non-display area to expose a top surface of the second pad in the non-display area, and expose a top surface of the passivation layer in the sealing area.

16. The display device of claim 1, wherein the second substrate comprises a second base portion facing the first base portion, a color filter layer on the second base portion, and a light conversion pattern layer on the color filter layer.

17. The display device of claim 16, further comprising a filler between the first substrate and the second substrate.
